(19) **Europäisches Patentamt / European Patent Office / Office européen des brevets**

(11) **EP 3 558 887 B1**

(12) **EUROPEAN PATENT SPECIFICATION**

(45) Date of publication and mention
of the grant of the patent:
**18.01.2023 Bulletin 2023/03**

(21) Application number: **17826347.1**

(22) Date of filing: **11.12.2017**

(51) International Patent Classification (IPC):
**C03C 17/42** (2006.01)

(52) Cooperative Patent Classification (CPC):
**C03C 17/42; C03C 2217/78**

(86) International application number:
**PCT/US2017/065507**

(87) International publication number:
**WO 2018/118467 (28.06.2018 Gazette 2018/26)**

(54) **GLASS-BASED ARTICLES HAVING CRACK MITIGATING SINGLE- AND MULTI-LAYER FILMS FOR RETAINED ARTICLE STRENGTH AND SCRATCH RESISTANCE**

GLASBASIERTER ARTIKEL MIT RISSABSCHWÄCHENDEN EIN- UND MEHRSCHICHTIGEN FOLIEN ZUR BEWAHRUNG DER ARTIKELFESTIGKEIT UND KRATZBESTÄNDIGKEIT

ARTICLES À BASE DE VERRE COMPORTANT DES FILMS MONOCOUCHE ET MULTICOUCHE ANTI-FISSURATION POUR UNE PLUS GRANDE RÉSISTANCE AUX RAYURES ET UNE SOLIDITÉ PRÉSERVÉE DE L'ARTICLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.12.2016 US 201662436657 P**

(43) Date of publication of application:
**30.10.2019 Bulletin 2019/44**

(73) Proprietor: **Corning Incorporated**
**Corning, New York 14831 (US)**

(72) Inventors:
• **BELLMAN, Robert, Alan**
**Painted Post, NY 14870 (US)**
• **FENG, Jiangwei**
**Newtown, PA 18940 (US)**
• **HART, Shandon Dee**
**Corning, NY 14830 (US)**
• **PRICE, James, Joseph**
**Corning, NY 14830 (US)**

(74) Representative: **Elkington and Fife LLP**
**Prospect House**
**8 Pembroke Road**
**Sevenoaks, Kent TN13 1XR (GB)**

(56) References cited:
**WO-A1-2016/138195      WO-A1-2016/176383**

**Description**

**BACKGROUND**

This disclosure relates to articles with a glass-based substrate that has a scratch-resistant film disposed on its surface, and a modified interface between the film and the glass-based substrate such that the glass-based substrate substantially retains its average flexural strength, and the film retains properties for its application, including the optical properties and scratch resistance associated with display device applications.

Articles including a glass-based substrate, which may be strengthened or strong as described herein, have found wide usage recently as a protective cover glass for displays, especially in touch-screen applications, and there is a potential for their use in many other applications, for example automotive or architectural windows, glass for photovoltaic systems and glass-based substrates for use in other electronic device applications. Further, such articles are often used in consumer electronic products to protect devices within the product, to provide a user interface for input and/or display, and/or many other functions. These consumer electronic products include mobile devices, for example smart phones, mp3 players and computer tablets.

Strong optical performance is beneficial in many of these articles in terms of maximum light transmission and minimum reflectivity when the articles are used in cover substrate and in some housing substrate applications. In addition, in cover substrate applications it is desirable that the color exhibited or perceived, in reflection and/or transmission, does not change appreciably as the viewing angle (or incident illumination angle) is changed. That is, if the color, reflectivity or transmission changes with viewing angle to an appreciable degree, the user of the product incorporating the cover glass will perceive a change in the color or brightness of the display, which can diminish the perceived quality of the display. Of these changes, a change in color is often the most noticeable and objectionable to users.

In many of these applications it can be advantageous to apply a scratch-resistant film to the glass-based substrates. Such scratch-resistant films can also include other functional film(s) and/or layer(s) disposed between an outer scratch-resistant film and the substrate. As such, exemplary scratch-resistant films can include one or more layers or films of the following materials: indium-tin-oxide (ITO) or other transparent conductive oxides (e.g., aluminum and gallium doped zinc oxides and fluorine doped tin oxide), hard films of various kinds (e.g., diamond-like carbon, $Al_2O_3$, AlN, $AlO_xN_y$, $Si_3N_4$, $SiO_xN_y$, $Si_uAl_xO_yN_z$, TiN, TiC), IR or UV reflecting layers, conducting or semiconducting layers, electronics layers, thin-film-transistor layers, or anti-reflection (AR) films (e.g., $SiO_2$, $Nb_2O_5$ and $TiO_2$ layered structures). These scratch-resistant films, whether stand-alone or multi-layer, must necessarily have a high scratch resistance and are often hard and/or have a high elastic modulus, or otherwise their other functional properties or those of the substrate beneath them (e.g., mechanical, durability, electrical conductivity, and/or optical properties) will be degraded. In most cases these scratch-resistant films are thin films; consequently, they generally have a thickness in the range of 0.005 $\mu$m to 10 $\mu$m (e.g., 5 nm to 10,000 nm).

When a scratch-resistant film is applied to a surface of a glass-based substrate, which may be strengthened or characterized as strong, the average flexural strength of the glass-based substrate may be reduced, for example, when evaluated using ring-on-ring strength testing. This behavior has been measured to be independent of temperature effects (i.e., the behavior is not caused by significant or measurable relaxation of surface compressive stress in the strengthened glass-based substrate due to any heating). The reduction in average flexural strength is also apparently independent of any glass surface damage or corrosion from processing, and is apparently an inherent mechanical attribute of the article, even when thin, scratch-resistant films having a thickness in the range from about 5 nm to about 10 $\mu$m are applied to the article. Without being bound by theory, this reduction in average flexural strength is believed to be associated with the adhesion between such films relative to the strengthened or strong glass-based substrates, the initially high average flexural strength (or high average strain-to-failure) of selected strengthened or strong glass-based substrates relative to selected, scratch-resistant films, together with crack bridging between such a film and the glass-based substrate.

When these articles employing glass-based substrates are employed in certain electronic device applications, for example, they may be subjected to additional high temperature processing during manufacturing. More specifically, the articles can be subjected to additional thermal treatments after deposition of the scratch-resistant film on the glass-based substrates. These additional high temperature treatments often are the result of application-specific development of additional structures and components on the substrates and/or films of the article. Further, the deposition of the scratch-resistant film itself on the substrate can be conducted at relatively high temperatures.

In view of these new understandings, there is a need to prevent scratch-resistant films from reducing the average flexural strength of glass-based substrates in these articles. There is also a need to ensure that the average flexural strength of the glass-based substrates is substantially retained, even after high temperature exposures from scratch-resistant film deposition processes and additional application-specific thermal treatments. In addition, a need also exists for retaining the scratch-resistance and optical properties of the substrate and scratch-resistant film in view of the additional design, configuration and/or processing of the interface between the substrate and the scratch-resistant film.

That is, there is a need to retain scratch-resistance and optical properties of the article upon the introduction of additional interfacial features aimed at retaining strength of the article.

WO 2016/138195 A1 relates to optical structures with multilayer stacks having high hardness.

WO 2016/176383 A1 relates to glass articles having films with moderate adhesion, retained strength and optical transmittance.

## SUMMARY

The invention relates to an article including a glass-based substrate having opposing major surfaces, a crack mitigating stack disposed on one of the major surfaces, and a scratch-resistant film disposed on the crack mitigating layer, the film having an elastic modulus greater than or equal to the elastic modulus of the glass-based substrate. The crack mitigating stack comprises one or more bi-layers, wherein each bi-layer is defined by: (a) a first layer comprising an organosilicate material, and (b) a second layer comprising an organosilicate material over the first layer, the first layer having a lower elastic modulus than the elastic modulus of the second layer. Further, the scratch-resistant film comprises at least one of a metal-containing oxide, a metal-containing oxynitride, a metal-containing nitride, a metal-containing carbide, a silicon-containing polymer, a carbon, a semiconductor, and combinations thereof. In addition, the article is characterized by an average flexural strength that is at least 70% of an average flexural strength of the substrate.

In an embodiment, the first layer may be characterized by an elastic modulus from about 1 GPa to about 20 GPa, and the second layer is characterized by an elastic modulus from about 10 GPa to about 40 GPa.

In a further embodiment, the first layer may be further characterized by a thickness from about 20 nanometers to about 70 nanometers, and the second layer is further characterized by a thickness from about 5 nanometers to about 40 nanometers.

In a further embodiment, the crack mitigating stack may have a thickness from about 50 nanometers to about 500 nanometers.

In a further embodiment, the crack mitigating stack may comprise N bi-layers, and N is from 2 to 10.

In an embodiment of the above embodiment, N may be equal to 3.

In a further embodiment, the scratch-resistant film may comprise silicon nitride.

In a further embodiment, the scratch-resistant film may comprise $SiO_2$, $Al_2O_3$, $TiO_2$, $Nb_2O_5$, $Ta_2O_5$, $SiO_xN_y$, $Si_uAl_xO_yN_z$, $AlO_xN_y$, $SiN_x$, $AlN_x$, cubic boron nitride, $TiN_x$, SiC, TiC, WC, Si, Ge, indium-tin-oxide, tin oxide, fluorinated tin oxide, aluminum zinc oxide, zinc oxide, carbon nanotubes, graphene-doped oxide, siloxane-containing polymer, silsesquioxane-containing polymer, diamond-like-carbon, and combinations thereof.

In a further embodiment, the first and the second layers may be defined by different compositions.

In a further embodiment, the optical transmittance of a glass-based substrate with the crack mitigating stack disposed thereon may vary by 5% or less from the optical transmittance of the same glass-based substrate with no crack mitigating stack from wavelengths of 400 nanometers to 800 nanometers.

In a further embodiment, the scratch-resistant film may be characterized by substantially no peeling from the article upon exposure of the film to a Garnet scratch test under a 1 kg total load.

In a further embodiment, the first and second layers may be characterized by an elastic modulus from about 5 GPa to about 10 GPa, and from about 25 GPa to about 35 GPa, respectively.

In a further embodiment, the optical transmittance of the article may be about 80% or greater from wavelengths of 400 nanometers to 800 nanometers.

The invention further relates to a device including a housing having front, back and side surfaces; electrical components that are at least partially inside the housing; and a display at or adjacent to the front surface of the housing. Further, the article of the invention is at least one of disposed over the display and disposed as a portion of the housing.

## BRIEF DESCRIPTION OF THE DRAWINGS

FIG. 1A is an illustration of an article comprising a glass-based substrate, a scratch-resistant film and a crack mitigating layer, according to one or more embodiments.

FIG. 1B is an illustration of an article comprising a glass-based substrate, a scratch-resistant film and a crack mitigating stack, according to one or more embodiments.

FIG. 2 is a schematic diagram of the development of a crack in a film or layer and its possible bridging modes.

FIG. 3 is an illustration of the theoretical model for the presence of a crack in a film or layer and its possible bridging as a function of elastic mismatch $\alpha$.

FIG. 4 is a diagram illustrating the energy release ratio $G_d/G_p$.

FIG. 5A is a schematic diagram of adhesive failures associated with a crack mitigating layer or crack mitigating stack interposed between a scratch-resistant film and a glass-based substrate according to some embodiments of this disclosure.

FIG. 5B is a schematic diagram of a cohesive failure in a crack mitigating layer or stack interposed between a scratch-resistant film and a glass-based substrate according to some embodiments of this disclosure.

FIG. 6 is a graph presenting ring-on-ring load-to-failure performance of glass-based substrate controls; substrates having silicon nitride scratch-resistant films (2 $\mu$m and 440 $\mu$m); reference substrates having a silicon nitride scratch-resistant film (440 $\mu$m) and a trimethylsilane-based (TMS) organosilicate crack mitigating layer; and substrates having a silicon nitride scratch-resistant film (440 $\mu$m) and a TMS-based organosilicate crack mitigating stack according to aspects of this disclosure given by Examples 1A-1C, 2A and 2B.

FIG. 7 is a graph presenting optical transmittance and reflectance data as a function of wavelength in the visible spectrum for glass-based substrate controls; reference glass-based substrates having a single layer, TMS-based organosilicate crack mitigating layer; and glass-based substrates having a multi-layer TMS-based organosilicate crack mitigating stack according to some embodiments of this disclosure given by Examples 1A, 2A and 2B.

FIG. 8 is a graph presenting absorption and haze (i.e., absorption and haze equals 1 - (reflectance + transmittance)) data for the samples depicted in FIG. 7 as a function of wavelength in the visible spectrum.

FIG. 9A is a transmittance color map showing a* and b* color coordinates for the samples depicted in FIG. 7 under D65 illumination.

FIG. 9B a reflectance color map showing a* and b* color coordinates for the samples depicted in FIG. 7 under D65 illumination.

FIG. 10 is a graph of Fourier transform infrared (FTIR) spectroscopy spectrums for TMS-based organosilicate coatings processed under various TMS and oxygen gas flow ratios.

FIG. 11 is top plan view of a device according to one or more embodiments.

FIG. 12 is perspective view of the device shown in FIG. 11.

## DETAILED DESCRIPTION

In the following detailed description, numerous specific details may be set forth in order to provide a thorough understanding of embodiments of the disclosure. However, it will be clear to one skilled in the art when embodiments of the disclosure may be practiced without some or all of these specific details. In other instances, well-known features or processes may not be described in detail so as not to unnecessarily obscure the disclosure. In addition, like or identical reference numerals may be used to identify common or similar elements.

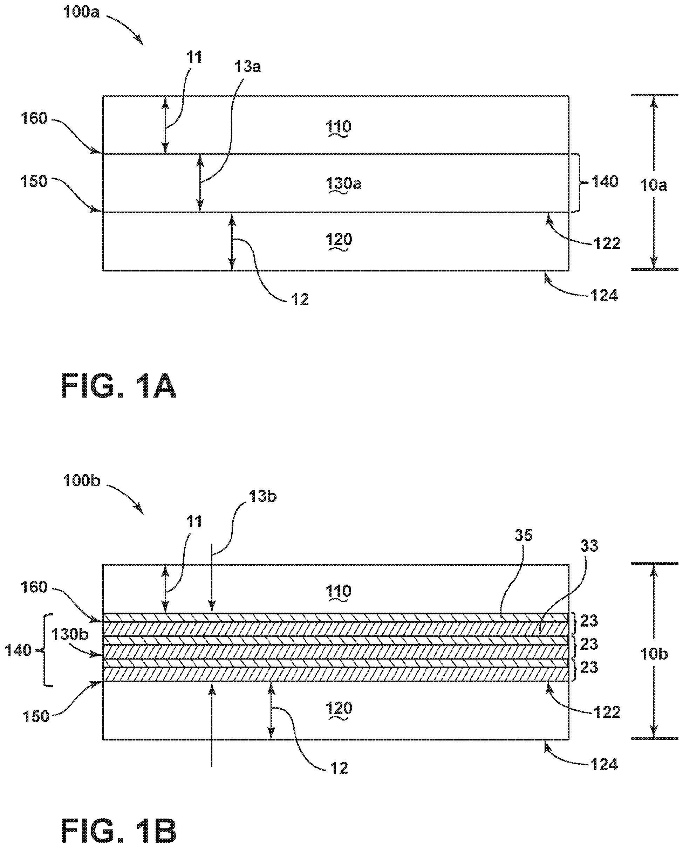

Referring to FIG. 1A, aspects of this disclosure, outside the scope of the claims include a laminate article 100a having a total stack thickness 10a. The article 100a also includes a scratch-resistant film 110 with a thickness 11, a glass-based substrate 120 with a thickness 12 and a crack mitigating layer 130a with a thickness 13a comprising an organosilicate material. In these aspects, the crack mitigating layer 130a includes one or more layers, typically with the same or substantially the same composition and characterized by an elastic modulus from about 1 GPa to about 25 GPa. In certain aspects, the scratch-resistant film 110 comprises at least one of a metal-containing oxide, a metal-containing oxynitride, a metal-containing nitride, a metal-containing carbide, a silicon-containing polymer, a carbon, a semiconductor, and combinations thereof. In some embodiments of the laminate article 100a, the scratch-resistant film 110 comprises silicon nitride.

Thickness of the thin film elements (e.g., crack mitigation layer, scratch-resistant film, crack mitigation stack, etc.) was measured by scanning electron microscope (SEM) of a cross-section, or by optical ellipsometry (e.g., by an n & k analyzer), or by thin film reflectometry. For multiple layer elements (e.g., crack miticagion stack), thickness measurements by SEM are preferred. To measure the elastic modulus of the thin film elements a proxy layer was used. The proxy layer was made of the same material and was deposited by the same process used to generate the coating, but was deposited 300 nm thick onto a Gorilla® Glass substrate. Hardness and Yuong's modulus of thin film coatings are determined using widely accepted nanoindentation practices. See: Fischer-Cripps, A.C., Critical Review of Analysis and Interpretation of Nanoindentation Test Data, Surface & Coatings Technology, 200, 4153 - 4165 (2006) (hereinafter "Fischer-Cripps"); and Hay, J., Agee, P, and Herbert, E., Continuous Stiffness measurement During Instrumented Indentation Testing, Experimental Techniques, 34 (3) 86 - 94 (2010) (hereinafter "Hay"). For coatings, it is typical to measure hardness and modulus as a function of indentation depth. So long as the coating is of sufficient thickness, it is then possible to isolate the properties of the coating from the resulting response profiles. It should be recognized that if the coatings are too thin (for example, less than ~500 nm), it may not be possible to completely isolate the coating properties as they can be influenced from the proximity of the substrate which may have different mechanical properties. See Hay. The methods used to report the properties herein are representative of the coatings themselves. The process is to measure hardness and modulus versus indentation depth out to depths approaching 1000 nm. In the case of hard coatings on a softer glass, the response curves will reveal maximum levels of hardness and modulus at relatively small indentation depths (</= about 200 nm). At deeper indentation depths both hardness and modulus will gradual diminish as the response is influenced by the softer glass substrate. In this case the coating hardness and modulus are taken be those associated with the regions exhibiting the maximum hardness and modulus. In the case of soft coatings on a harder glass substrate, the coating properties will be indicated by lowest hardness and modulus levels that occur at relatively small indentation depths. At deeper indentation depths, the hardness and modulus will gradually increase due to the influence of the harder glass. These profiles of hardness and modulus versus depth can be obtained using either the traditional Oliver and Pharr approach (as described in Fischer-Cripps) or by the more efficient continuous stiffness approach (see Hay). Extraction of reliable nanoindentation data requires that well-established protocols be followed. Otherwise, these metrics can be subject to significant errors.

Within the article 100a, the interfacial properties at an effective interface 140 between the scratch-resistant film 110 and the crack mitigating layer 130a or the crack mitigating layer 130a and the substrate 120 are modified, generally by virtue of the crack mitigating layer 130a, such that the article 100a substantially retains its average flexural strength, and the film 110 retains functional properties for its application, particularly scratch resistance.

Referring now to FIG. 1B, aspects of the invention include a laminate article 100b having a total stack thickness 10b. The article 100b also include a scratch-resistant film 110, a glass-based substrate 120, and a crack mitigating stack 130b having a thickness 13b and comprising an organosilicate material. The laminate article 100b is similar to the laminate article 100a; consequently, like-numbered elements have the same or similar structure and function(s). Further, the crack mitigating stack 130b includes one or more bi-layers 23, each made of a first layer 33 and a second layer 35. In certain aspects, the crack mitigating stack 130b includes N bi-layer 23, with N ranging from about 2 to 10 bi-layers 23. In some embodiments, the number N of bi-layers 23 is equal to three; consequently, there are three bi-layers 23 and a total of six first and second layers 33, 35.

Each bi-layer 23 of the laminate article 100b (see FIG. 1B) is defined by a first layer 33 comprising an organosilicate material and a second layer 35 comprising an organosilicate material over the first layer 33 in which the first layer 33 has a lower elastic modulus than the elastic modulus of the second layer 35. The first and second layers 33, 35 typically have a similar composition, but with differing elastic moduli. In certain embodiments, the first and second layers 33, 35 have differing compositions which influence differences in their properties, including elastic modulus. In certain embodiments, the first layer 33 is characterized by an elastic modulus from about 1 GPa to about 20 GPa and the second layer 35 is characterized by an elastic modulus from about 10 GPa to about 40 GPa. In certain aspects, the scratch-resistant film 110 comprises at least one of a metal-containing oxide, a metal-containing oxynitride, a metal-containing nitride, a metal-containing carbide, a silicon-containing polymer, a carbon, a semiconductor, and combinations thereof.

Within the article 100b, the interfacial properties at an effective interface 140 between the scratch-resistant film 110 and the crack mitigating stack 130b or between the crack mitigating stack 130b and the substrate 120 are modified, generally by virtue of the crack mitigating stack 130b, such that the article 100b substantially retains its average flexural strength, and the scratch-resistant film 110 retains functional properties for its application, particularly scratch-resistance.

As understood in this disclosure, the term "scratch-resistant film" and the "scratch-resistant film 110" can include one or more films, layers, structures and combinations thereof. It should also be understood that for a "film" that includes more than one film, layer, structure, etc., the refractive index associated with the "film" is the aggregate or composite refractive index of the films, layers, structures, etc. that make up the "film."

Referring again to FIGS. 1A and 1B, aspects of this disclosure include a laminate article 100a, 100b including a glass-based substrate 120 and a crack mitigating layer 130a (outside the scope of the claims) or stack 130b. Within the article 100a, 100b, the interfacial properties at an effective interface 140 between the crack mitigating layer 130a or stack 130b and the substrate 120 are modified such that the article 100a, 100b substantially retains its average flexural strength. In further embodiments, the interfacial properties at an effective interface 140 between the crack mitigating layer 130a or stack 130b and the substrate 120 are modified such that the article 100a, 100b substantially retains at least 70%, at least 80%, or at least 90% of its average flexural strength. In additional implementations, the interfacial properties at the effective interface 140 are modified such that the article 100a, 100b substantially retains its scratch resistance, particularly the scratch resistance associated with the scratch-resistant film 110.

In one or more embodiments, the laminate article 100a, 100b exhibits functional properties that are also retained after such interface modifications, e.g., scratch resistance. Functional properties of the scratch-resistant film 110 and/or articles 100a, 100b may include optical properties, electrical properties and/or mechanical properties, for example hardness, elastic modulus, strain-to-failure, abrasion resistance, scratch resistance, mechanical durability, coefficient of friction, electrical conductivity, electrical resistivity, electron mobility, electron or hole carrier doping, optical refractive index, density, opacity, transparency, reflectivity, absorptivity, transmissivity and the like. The refractive index was measured using an Model 1512-RT analyzer, supplied by n&k Technology, Inc., located in San Jose, CA, which uses spectroscopic ellipsometry, as is known in the art. In certain implementations, the optical properties of the articles 100a, 100b are retained, independent of the properties and/or processing of the crack mitigating layer 130a or stack 130b. In certain aspects, the optical transmittance of the substrate 120 and the crack mitigating layer 130a or stack 130b can vary by 1% or less from the optical transmittance of the substrate 120 (e.g., from wavelengths of 400 nm to 800 nm). These functional properties of the articles 100a, 100b can be retained after combination with the crack mitigating layer 130a and stack 130b, and before any separation of the crack mitigating layer 130a and stack 130b from the glass-based substrate 120 as described herein.

In one or more embodiments of laminate articles 100a, 100b, the modification to the effective interface 140 between the scratch-resistant film 110 and the glass-based substrate 120 includes preventing one or more cracks from bridging from one of the film 110 or the glass-based substrate 120 into the other of the film 110 or the glass-based substrate 120, while preserving other functional properties of the film 110 and/or the article. In one or more specific embodiments, as illustrated in FIGS. 1A and 1B, the modification of the interfacial properties includes disposing a crack mitigating layer 130a or stack 130b between the glass-based substrate 120 and the scratch-resistant film 110. In one or more embodiments, the crack mitigating stack 130b is disposed on the glass-based substrate 120 and forms a first interface 150, and the film 110 is disposed on the crack mitigating stack 130b forming a second interface 160. The effective interface 140 includes the first interface 150, the second interface 160 and/or the crack mitigating stack 130b.

With regard to the laminate articles 100a and 100b depicted in FIGS. 1A and 1B, the term "scratch-resistant film," as applied to the scratch-resistant film 110 and/or other films incorporated into the article 100a, 100b, includes one or more layers that are formed by any known method in the art, including discrete deposition or continuous deposition processes. Such layers may be in direct contact with one another. The layers may be formed from the same material or more than one different material. In one or more alternative embodiments, such layers may have intervening layers of different materials disposed therebetween. In one or more embodiments a scratch-resistant film may include one or more contiguous and uninterrupted layers and/or one or more discontinuous and interrupted layers (i.e., a layer having different materials formed adjacent to one another).

As used herein (e.g., in relation to laminate articles 100a, 100b), the term "dispose" includes coating, depositing and/or forming a material onto a surface using any known method in the art. The disposed material may constitute a layer or film as defined herein. The phrase "disposed on" includes the instance of forming a material onto a surface such that the material is in direct contact with the surface and also includes the instance where the material is formed on a surface, where one or more intervening material(s) is between the disposed material and the surface. The intervening material(s) may constitute a layer or film, as defined herein.

As used herein, the term "average flexural strength" is intended to refer to the flexural strength of a glass-containing material (e.g., an article and/or a glass-based substrate), as tested through ring-on-ring. The term "average" when used in connection with average flexural strength or any other property is based on the mathematical average of measurements of such property on 5 samples. Average flexural strength may refer to the scale parameter of two parameter Weibull statistics of failure load under ring-on-ring. This scale parameter is also called the Weibull characteristic strength, at which a material's failure probability is 63.2%. Glass surface strength may also be tested in a device configuration, where an appliance or device containing the glass-containing material (e.g., an article and/or a glass-based substrate) article is dropped in different orientations that may create a surface flexural stress. Average flexural strength may in some cases also incorporate the strength as tested by other methods known in the art, for example 3-point bend or 4-point bend testing. In some cases, these test methods may be significantly influenced by the edge strength of the article.

As used herein, the terms "bridge," or "bridging," refer to crack, flaw or defect formation and such crack, flaw or defect's growth in size and/or propagation from one material, layer or film into another material, layer or film. For example, bridging includes the instance where a crack that is present in the scratch-resistant film 110 propagates into another material, layer or film (e.g., the glass-based substrate 120). The terms "bridge" or "bridging" also include the instance where a crack crosses an interface between different materials, different layers and/or different films. The materials, layers and/or films need not be in direct contact with one another for a crack to bridge between such materials, layers and/or films. For example, the crack may bridge from a first material into a second material, not in direct contact with the first material, by bridging through an intermediate material disposed between the first and second material. The same scenario may apply to layers and films and combinations of materials, layers and films. In the laminate articles 100a, 100b described herein, a crack may originate in one of the scratch-resistant film 110 or the glass-based substrate 120 and bridge into the other of the scratch-resistant film 110 or the glass-based substrate 120 across the effective interface 140 (and specifically across the first interface 150 and the second interface 160).

As will be described herein in connection with the laminate articles 100a, 100b, the crack mitigating layer 130a or stack 130b may deflect cracks from bridging between the scratch-resistant film 110 and the glass-based substrate 120, regardless of where (i.e., the film 110 or the glass-based substrate 120) the crack originates. Likewise, the crack mitigating layer 130a or stack 130b of the laminate articles 100a, 100b may deflect cracks from bridging between the layer or stack 130a, 130b and the glass-based substrate 120. Crack deflection may include at least partial delamination of the crack mitigating layer 130a or stack 130b from the film 110 and/or glass-based substrate 120, as described herein, upon bridging of the crack from one material (e.g., the film 110, glass-based substrate 120 or crack mitigating layer/stack 130a/130b) to another material (e.g., the film 110, glass-based substrate 120 or crack mitigating layer/stack 130a/130b). Crack deflection may also include causing a crack to propagate through the crack mitigating layer 130a or stack 130b instead of propagating into the film 110 and/or the glass-based substrate 120. In such instances, the crack mitigating layer 130a or stack 130b may form a low toughness interface at the effective interface 140 that facilitates crack propagation through the crack mitigating layer instead of into the glass-based substrate or film. This type of mechanism may be described as deflecting the crack along the effective interface 140.

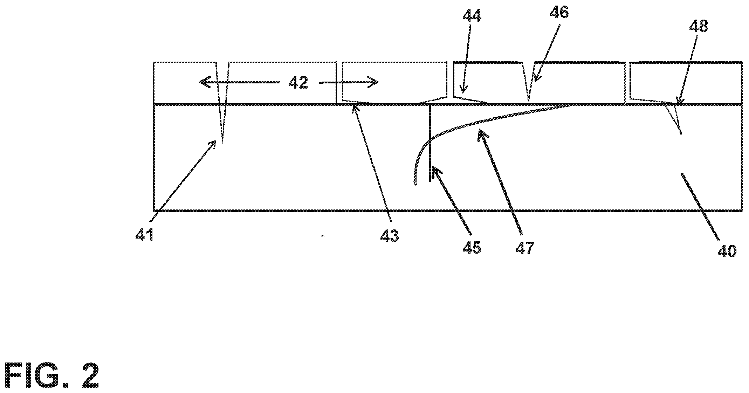

The following theoretical fracture mechanics analysis illustrates selected ways in which cracks may bridge or may be mitigated within a laminated article, e.g., laminate articles 100a, 100b (see FIGS. 1A and 1B). FIG. 2 is a schematic illustrating the presence of a crack in a film disposed on a glass-based substrate and its possible bridging or mitigation modes. The numbered elements in FIG. 2 are the glass-based substrate 40 (e.g., comparable to glass-based substrate 120 in FIGS. 1A and 1B), the film 42 (e.g., comparable to the scratch-resistant film 110) on top of a surface (unnumbered) of glass-based substrate 40, a two-sided deflection 44 into the interface between glass-based substrate 40 and film 42, an arrest 46 (which is a crack that started to develop in film 42 but did not go completely through film 42), a "kinking" 48 (which is a crack that developed in the surface of film 42, but when it reached the surface of the glass-based substrate 40 it did not directly penetrate into the glass-based substrate 40, but instead moves in a lateral direction as indicated in FIG. 2 and then penetrates the surface of the glass-based substrate 40 at another position), a penetration crack 41 that developed in the film 42 and penetrated into the glass-based substrate 40, and a one-sided deflection 43. FIG. 2 also shows a graph of tension vs. compression 47 in the glass-based substrate 40 compared to zero axis 45. With the page in portrait orientation, i.e., with line 45 horizontally and the numeral 48 at the top, the lines 45 and 47 represent a graph of the stress profile superimposed on the picture. In this orientation, line 45 represents the x-axis of the graph with a value of zero stress. High compressive stress at the glass surface is shown by line 47 and tensile stress in the depth of the glass is also shown when line 47 dips below line 45. As illustrated, upon application of external loading (in such cases, tensile loading is the most detrimental situation), the flaws in the film can be preferentially activated to form cracks prior to the development of cracks in the residually compressed or strengthened glass-based substrate. In the scenarios illustrated in FIG. 2, with continued increase of external loading, the cracks will bridge until they encounter the glass-based substrate. When the cracks, upon origination in the film 42, reach the surface of glass-based substrate 40, the possible bridging modes of the crack are: (a) penetration into the glass-based substrate without changing its path as represented by numeral 41; (b) deflection into one side along the interface between the film and the glass-based substrate as indicated by numeral 43; (c) deflection into two sides along the interface as indicated by numeral 44; (d) first deflection along the interface and then kinking into the glass-based substrate as indicated by numeral 48; or (e) crack arrest as indicated by numeral 46 due to microscopic deformation mechanisms, for example, plasticity, nano-scale blunting, or nano-scale deflection at the crack tip. Cracks may originate in the film and may bridge into the glass-based substrate. The above-described bridging modes are also applicable where cracks originate in the glass-based substrate and bridge into the film, for example where pre-existing cracks or flaws in the glass-based substrate may induce or nucleate cracks or flaws in the film, thus leading to crack growth or propagation from the glass-based substrate into the film, resulting in crack bridging.

Crack penetration into the glass-based substrate 120 and/or scratch-resistant film 110 reduces the average flexural strength of the laminated articles 100a, 100b (see FIGS. 1A and 1B) and the glass-based substrate 120 as compared to the average flexural strength of the glass-based substrate 120 alone (i.e., without a scratch-resistant film or a crack mitigating layer/stack), while crack deflection, crack blunting or crack arrest (collectively referred to herein as crack mitigation) helps retain the average flexural strength of the articles. "Crack blunting" and "crack arrest" can be distinguished from one another. "Crack blunting" may comprise an increasing crack tip radius, for example, through plastic deformation or yielding mechanisms. "Crack arrest," on the other hand, could comprise a number of different mechanisms for example, for example, encountering a highly compressive stress at the crack tip, a reduction of the stress intensity factor at the crack tip resulting from the presence of a low-elastic modulus interlayer or a low-elastic modulus-to-high-elastic modulus interface transition; nano-scale crack deflection or crack tortuosity as in some polycrystalline or composite materials, strain hardening at the crack tip and the like. The various modes of crack deflection will be described herein.

Without being bound by theory, certain possible crack bridging paths can be analyzed in the context of linear elastic fracture mechanics. In the following paragraphs, one crack path is used as an example and the fracture mechanics concept is applied to the crack path to analyze the problem and illustrate the desired material parameters to help retain the average flexural strength performance of the article, for a particular range of material properties.

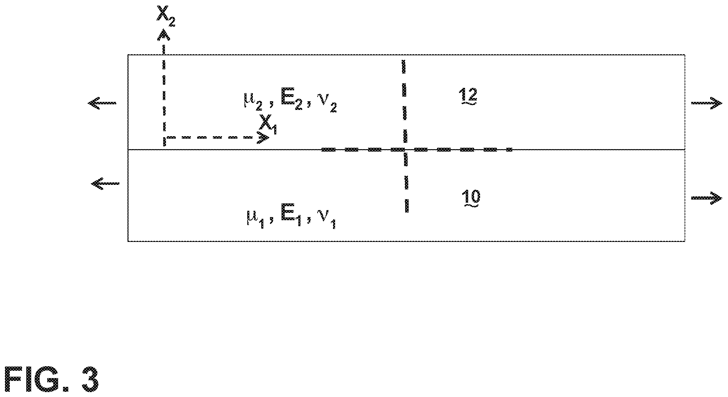

FIG. 3 shows the illustration of the theoretical model framework. This is a simplified schematic view of the interface region between the film 12 and glass-based substrate 10. The terms $\mu_1$, $E_1$, $\nu_1$, and $\mu_2$, $E_2$, $\nu_2$, are respective shear modulus, Young's modulus (elastic modulus), Poisson's ratio of the glass-based substrate and film materials, $\Gamma_c^{Glass}$ and $\Gamma_c^{IT}$ are are critical energy release rate of glass-based substrate and the interface between substrate and film, respectively.

The common parameters to characterize the elastic mismatch between the film and the substrate are Dundurs' parameters $\alpha$ and $\beta$, as defined below

$$\alpha = \frac{\bar{E}_1 - \bar{E}_2}{\bar{E}_1 + \bar{E}_2} \tag{1}$$

where $\bar{E} = E/(1 - \nu^2)$ for plain strain and

$$\beta = \frac{1}{2} \frac{\mu_1 (1 - 2\nu_2) - \mu_2 (1 - 2\nu_1)}{\mu_1 (1 - \nu_2) + \mu_2 (1 - \nu_1)} \tag{2}$$

It is worth pointing out that critical energy release rate is closely related with the fracture toughness of the material through the relationship defined as

$$\Gamma = \frac{1 - \nu^2}{E} K_C^2 \tag{3}$$

Under the assumption that there is a pre-existing flaw in the film, upon tensile loading the crack will extend vertically down as illustrated in FIG. 3. Right at the interface, the crack tends to deflect along the interface if

$$\frac{G_d}{G_p} \geq \frac{\Gamma_c^{IT}}{\Gamma_c^{Glass}} \tag{4}$$

and the crack will penetrate into the glass-based substrate if

$$\frac{G_{dc}}{G_{pc}} < \frac{\Gamma^{IT}}{\Gamma^{Glass}} \tag{5}$$

where $G_d$ and $G_p$ and are the energy release rates of a deflected crack along the interface and a penetrated crack into the glass-based substrate, respectively. On the left hand side of equations (4) and (5), the ratio $G_d/G_p$ is a strong function of elastic mismatch parameter $\alpha$ and weakly dependent on $\beta$; and on the right hand side, the toughness ratio $\Gamma_c^{IT}/\Gamma_c^{Glass}$ is a material parameter.

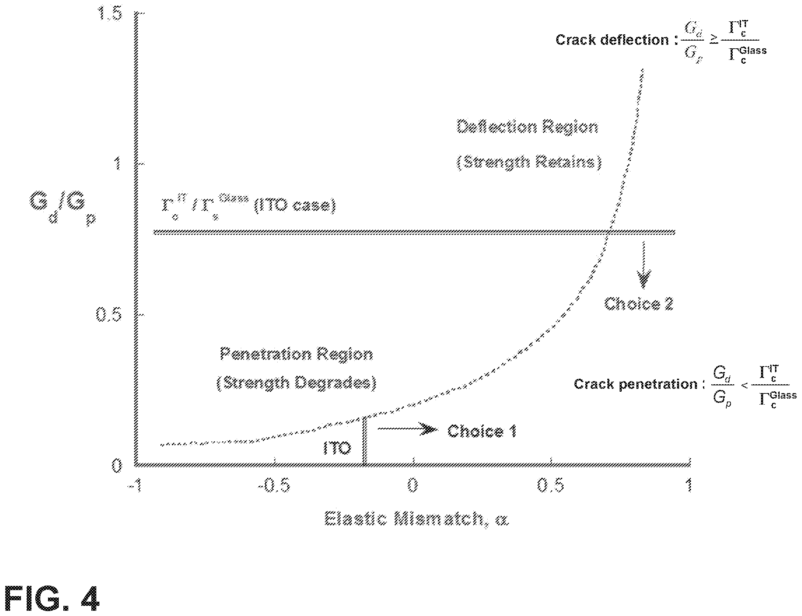

FIG. 4 graphically illustrates the trend of $G_d/G_p$ as a function of elastic mismatch $\alpha$, reproduced from a reference for doubly-deflected cracks. (See Ming-Yuan, H. and J.W. Hutchinson, "Crack deflection at an interface between dissimilar elastic materials," International Journal of Solids and Structures, 1989, 25(9): pp. 1053-1067.)

It is evident that the ratio $G_d/G_p$ is strongly dependent on $\alpha$. Negative $\alpha$ means the film is stiffer than the glass-based substrate and positive $\alpha$ means the film is softer than the glass-based substrate. The toughness ratio $\Gamma_c^{IT}/\Gamma_c^{Glass}$, which is independent of $\alpha$, is a horizontal line in FIG. 4. If the criterion in Equation (4) is satisfied, in FIG. 4, at the region above the horizontal line, the crack tends to deflect along the interface which may be beneficial for the retention of the average flexural strength of a substrate. On the other hand, if the criterion in Equation (5) is satisfied, in FIG. 4, at the region below the horizontal line, the crack tends to penetrate into glass-based substrate which leads to degradation of the average flexural strength of the article, particularly those articles utilizing strengthened or strong glass-based substrates as described elsewhere herein.

With the above concept, in the following, an indium-tin-oxide (ITO) film (e.g., as a scratch-resistant film 110 comprising ITO) is utilized as an illustrative example. For glass-based substrate, $E_1$ = 72 GPa, $\nu_1$ = 0.22, and $K_{1c}$ = 0.7 MPa·m$^{1/2}$; for ITO, $E_2$ = 99.8 GPa, and $\nu_2$ = 0.25. (Zeng, K., et al., "Investigation of mechanical properties of transparent conducting oxide thin films." Thin Solid Films, 2003, 443(1-2): pp. 60-65.) The interfacial toughness between the ITO film and glass-based substrate can be approximately $\Gamma_{in}$ = 5 J/m$^2$, depending on deposition conditions. (Cotterell, B. and Z. Chen, "Buckling and cracking of thin films on compliant substrates under compression," International Journal of Fracture, 2000, 104(2): pp. 169-179.) This will give the elastic mismatch $\alpha$ = -0.17 and $\Gamma_c^{IT}/\Gamma_c^{Glass} = 0.77$ . These values are plotted in FIG. 4. This fracture analysis predicts that the crack penetration into the glass-based substrate for the ITO film will be favored, which leads to degradation of the average flexural strength of the glass-based substrate, particularly a glass-based substrate that is strengthened or strong. This is believed to be one of the potential underlying mechanisms observed with various scratch-resistant films, including those films comprising indium-tin-oxide or other transparent conductive oxides, disposed on glass-based substrates, including strengthened or strong glass-based substrates. As shown in FIG. 4, one way to mitigate the degradation of the average flexural strength can be to select appropriate materials to change the elastic mismatch $\alpha$ ("Choice 1") or to adjust the interfacial toughness ("Choice 2"), i.e., Choice 2 would move the Gd/Gp line downward.

The theoretical analysis outlined above suggests that a crack mitigating layer 130a or stack 130b can be used to better retain the strength of laminate articles 100a, 100b, respectively. Specifically, the insertion of a crack mitigating layer 130a or stack 130b between a glass-based substrate 120 and a scratch-resistant film 110 (for articles 100) makes crack mitigation, as defined herein, a more preferred path and thus the article is better able to retain its strength. In some embodiments, the crack mitigating layer 130a or stack 130b facilitates crack deflection, as will be described in greater detail herein.


Glass-based substrate

Referring to FIGS. 1A and 1B, the laminate articles 100a, 100b include a glass-based substrate 120, which may be strengthened or strong, as described herein, having opposing major surfaces 122, 124. Laminate article 100a, 100b also includes a scratch-resistant film 110 disposed over at least one opposing major surface (122 or 124) of the substrate. In addition, laminate articles 100, 100a include a crack mitigating layer 130a or stack 130b. With regard to articles 100a, 100b the crack mitigating layer 130a or stack 130b is disposed between the scratch-resistant film 110 and the glass-based substrate 120. In one or more alternative embodiments, the crack mitigating layer 130a, stack 130b and/or the scratch-resistant film 110 may be disposed on the minor surface(s) of the glass-based substrate in addition to or instead of being disposed on at least one major surface (e.g., surfaces 122 or 124).

As used herein, the glass-based substrate 120 may be substantially planar sheets, although other embodiments may utilize a curved or otherwise shaped or sculpted glass-based substrate. The glass-based substrate 120 may be substantially clear, transparent and free from light scattering. The glass-based substrate may have a refractive index in the range from about 1.45 to about 1.55. In one or more embodiments, the glass-based substrate 120 may be strengthened or characterized as strong, as will be described in greater detail herein. The glass-based substrate 120 may be relatively pristine and flaw-free (for example, having a low number of surface flaws or an average surface flaw size less than about 1 micron) before such strengthening. Where strengthened or strong glass-based substrates 120 are utilized, such substrates may be characterized as having a high average flexural strength (when compared to glass-based substrates that are not strengthened or strong) or high surface strain-to-failure (when compared to glass-based substrates that are not strengthened or strong) on one or more major opposing surfaces of such substrates.

Additionally or alternatively, the thickness 12 of the glass-based substrate 120 may vary along one or more of its dimensions for aesthetic and/or functional reasons. For example, the edges of the glass-based substrate 120 may be thicker as compared to more central regions of the glass-based substrate 120. The length, width and thickness dimensions of the glass-based substrate 120 may also vary according to the application or use of the article 100a, 100b.

The glass-based substrate 120 according to one or more embodiments includes an average flexural strength that may be measured before and after the glass-based substrate 120 is combined with the scratch-resistant film 110, crack mitigating stack 130b and/or other films or layers. In one or more embodiments described herein, the laminate articles 100a, 100b retain their average flexural strength after the combination of the glass-based substrate 120 with the scratch-resistant film 110, crack mitigating stack 130b and/or other films, layers or materials, when compared to the average flexural strength of the glass-based substrate 120 before such a combination. In other words, the average flexural strength of the articles 100a, 100b is substantially the same before and after the scratch-resistant film 110, crack mitigating stack 130b and/or other films or layers are disposed on the glass-based substrate 120. In one or more embodiments, the articles 100a, 100b have an average flexural strength that is significantly greater than the average flexural strength of similar articles that do not include the crack mitigating stack 130b (e.g., a higher strength value than an article that comprises scratch-resistant film 110 and glass-based substrate 120 in direct contact, without an intervening crack mitigating stack 130b). In other embodiments, the articles 100a, 100b have an average flexural strength that is at least 70% of the average flexural strength of similar articles comprising the glass-based substrates alone (i.e., with no other coatings or films).

In accordance with one or more embodiments, the glass-based substrate 120 has an average strain-to-failure that may be measured before and after the glass-based substrate 120 is combined with the scratch-resistant film 110, crack mitigating stack 130b and/or other films or layers. The term "average strain-to-failure" refers to the strain at which cracks propagate without application of additional load, typically leading to catastrophic failure in a given material, layer or film and, perhaps even bridge to another material, layer, or film, as defined herein. Average strain-to-failure was measured using ring-on-ring testing. Without being bound by theory, the average strain-to-failure may be directly correlated to the average flexural strength using appropriate mathematical conversions. In specific embodiments, the glass-based substrate 120, which may be strengthened or strong as described herein, has an average strain-to-failure that is 0.5% or greater, 0.6% or greater, 0.7% or greater, 0.8% or greater, 0.9% or greater, 1% or greater, 1.1% or greater, 1.2% or greater, 1.3% or greater, 1.4% or greater 1.5% or greater or even 2% or greater, and all ranges and sub-ranges between the foregoing values. In specific embodiments, the glass-based substrate has an average strain-to-failure of 1.2%, 1.4%, 1.6%, 1.8%, 2.2%, 2.4%, 2.6%, 2.8% or 3% or greater, and all ranges and sub-ranges between the foregoing values. The average strain-to-failure of the film 110 may be less than the average strain-to-failure of the glass-based substrate 120 and/or the average strain-to-failure of the crack mitigating layer 130. Without being bound by theory, it is believed that the average strain-to-failure of a glass-based substrate or any other material is dependent on the surface quality of such material. With respect to glass-based substrates, the average strain-to-failure of a specific glass-based substrate is dependent on the conditions of ion exchange or strengthening process utilized in addition to or instead of the surface quality of the glass-based substrate. In some embodiments, the glass-based substrate may have an elastic modulus from about 55 GPa to about 100 GPa, and all ranges and sub-ranges between the foregoing values. In other embodiments, the glass-based substrate may have an elastic modulus from about 55 GPa to about 80 GPa. Further, other implementations employ glass-based substrates with an elastic modulus from 60 GPa to 90 GPa.

In one or more embodiments, the glass-based substrate 120 retains its average strain-to-failure after combination with the scratch-resistant film 110, crack mitigating or stack 130b and/or other films or layers. In other words, the average strain-to-failure of the glass-based substrate 120 is substantially the same before and after the scratch-resistant film 110, crack mitigating or stack 130b and/or other films or layers are disposed on the glass-based substrate 120. In one or more embodiments, the articles 100a, 100b have an average strain-to-failure that is significantly greater than the average strain-to-failure of similar articles that do not include the crack mitigating stack 130b (e.g., a higher strain-to-failure than an article that comprises scratch-resistant film 110 and glass-based substrate 120 in direct contact, without an intervening crack mitigating layer or stack). For example, the articles 100a, 100b may exhibit average strain-to-failures that are at least 10% higher, 25% higher, 50% higher, 100% higher, 200% higher or 300% higher, and all ranges and sub-ranges between the foregoing values, than the average strain-to-failure of similar articles that do not include the crack mitigating stack 130b.

The glass-based substrate 120 may be provided using a variety of different processes. For example glass-based substrate forming methods include float glass processes, press rolling processes, tube forming processes, updraw processes, and down-draw processes for example fusion draw and slot draw. In the float glass process, a glass-based substrate that may be characterized by smooth surfaces and uniform thickness is made by floating molten glass on a bed of molten metal, typically tin. In an example process, molten glass that is fed onto the surface of the molten tin bed forms a floating glass ribbon. As the glass ribbon flows along the tin bath, the temperature is gradually decreased until the glass ribbon solidifies into a solid glass-based substrate that can be lifted from the tin onto rollers. Once off the bath, the glass-based substrate can be cooled further and annealed to reduce internal stress.

Down-draw processes produce glass-based substrates having a uniform thickness that may possess relatively pristine surfaces. Because the average flexural strength of the glass-based substrate is controlled by the frequency, amount and/or size of surface flaws, a pristine surface that has had minimal contact has a higher initial strength. When this high strength glass-based substrate is then further strengthened (e.g., chemically or thermally), the resultant strength can be higher than that of a glass-based substrate with a surface that has been lapped and polished. Down-drawn glass-based substrates may be drawn to a thickness of less than about 2 mm. In addition, down drawn glass-based substrates may have a very flat, smooth surface that can be used in its final application without costly grinding and polishing.

The fusion draw process, for example, uses a drawing tank that has a channel for accepting molten glass raw material. The channel has weirs that are open at the top along the length of the channel on both sides of the channel. When the channel fills with molten material, the molten glass overflows the weirs. Due to gravity, the molten glass flows down the outside surfaces of the drawing tank as two flowing glass films. These outside surfaces of the drawing tank extend down and inwardly so that they join at an edge below the drawing tank. The two flowing glass films join at this edge to fuse and form a single flowing glass-based substrate. The fusion draw method offers the advantage that, because the two glass films flowing over the channel fuse together, neither of the outside surfaces of the resulting glass-based substrate comes in contact with any part of the apparatus. Thus, the surface properties of the fusion drawn glass-based substrate are not affected by such contact.

The slot draw process is distinct from the fusion draw method. In slot draw processes, the molten raw material glass is provided to a drawing tank. The bottom of the drawing tank has an open slot with a nozzle that extends the length of the slot. The molten glass flows through the slot/nozzle and is drawn downward as a continuous substrate and into an annealing region.

Once formed, glass-based substrates may be strengthened to form strengthened glass-based substrates. As used herein, the term "strengthened glass-based substrate" may refer to a glass-based substrate that has been chemically strengthened, for example through ion-exchange of larger ions for smaller ions in the surface of the glass-based substrate. However, other strengthening methods known in the art, for example thermal tempering, may be utilized to form strengthened glass-based substrates. As will be described, strengthened glass-based substrates may include a glass-based substrate having a surface compressive stress in its surface that aids in the strength preservation of the glass-based substrate. As also used herein, "strong" glass-based substrates are also within the scope of this disclosure and include glass-based substrates that may not have undergone a specific strengthening process, and may not have a surface compressive stress, but are nevertheless strong as understood by those with ordinary skill in the art. Such strong glass-based substrate articles may be defined as glass sheet articles or glass-based substrates having an average strain-to-failure greater than about 0.5%, 0.7%, 1%, 1.5%, or even greater than 2%, and all ranges and sub-ranges between the foregoing values. These strong glass-based substrates can be made, for example, by protecting the pristine glass surfaces after melting and forming the glass-based substrate. An example of such protection occurs in a fusion draw method, where the surfaces of the glass films do not come into contact with any part of the apparatus or other surface after forming. The glass-based substrates formed from a fusion draw method derive their strength from their pristine surface quality. A pristine surface quality can also be achieved through etching or polishing and subsequent protection of glass-based substrate surfaces, and other methods known in the art. In one or more embodiments, both strengthened glass-based substrates and the strong glass-based substrates may comprise glass sheet articles having an average strain-to-failure greater than about 0.5%, 0.7%, 1%, 1.5%, or even greater than 2%, and all ranges and sub-ranges between the foregoing values, for example when measured using ring-on-ring testing.

As mentioned above, the glass-based substrates described herein may be chemically strengthened by an ion exchange process to provide a strengthened glass-based substrate 120. The glass-based substrate may also be strengthened by other methods known in the art, for example thermal tempering. In the ion-exchange process, typically by immersion of the glass-based substrate into a molten salt bath for a predetermined period of time, ions at or near the surface(s) of the glass-based substrate are exchanged for larger metal ions from the salt bath. In some embodiments, the temperature of the molten salt bath is about 350°C to 450°C and the predetermined time period is about two to about eight hours. The incorporation of the larger ions into the glass-based substrate strengthens the glass-based substrate by creating a compressive stress in a near surface region or in regions at and adjacent to the surface(s) of the glass-based substrate. A corresponding tensile stress is induced within a central region or regions at a distance from the surface(s) of the glass-based substrate to balance the compressive stress. Glass-based substrates utilizing this strengthening process may be described more specifically as chemically-strengthened glass-based substrates 120 or ion-exchanged glass-based substrates 120. Glass-based substrates that are not strengthened may be referred to herein as non-strengthened glass-based substrates.

In one example, sodium ions in a strengthened glass-based substrate 120 are replaced by potassium ions from the molten salt bath, for example a potassium nitrate salt bath, though other alkali metal ions having larger atomic radii, for example rubidium or cesium, can replace smaller alkali metal ions in the glass. According to particular embodiments, smaller alkali metal ions in the glass can be replaced by $Ag^+$ ions. Similarly, other alkali metal salts for example, but not limited to, sulfates, phosphates, halides, and the like may be used in the ion exchange process.

The replacement of smaller ions by larger ions at a temperature below that at which the glass network can relax produces a distribution of ions across the surface(s) of the strengthened glass-based substrate 120 that results in a stress profile. The larger volume of the incoming ion produces a compressive stress (CS) on the surface and tension (central tension, or CT) in the center of the strengthened glass-based substrate 120. Depth of exchange may be described as the depth within the strengthened glass-based substrate 120 (i.e., the distance from a surface of the glass-based substrate to a central region of the glass-based substrate), at which ion exchange facilitated by the ion exchange process takes place.

Compressive stress (at the surface of the glass) is measured by surface stress meter (FSM) using commercially available instruments such as the FSM-6000, manufactured by Orihara Industrial Co., Ltd. (Japan). Surface stress measurements rely upon the accurate measurement of the stress optical coefficient (SOC), which is related to the birefringence of the glass. SOC in turn is measured according to Procedure C (Glass Disc Method) described in ASTM standard C770-16, entitled "Standard Test Method for Measurement of Glass Stress-Optical Coefficient,".

As used herein, depth of compression (DOC) means the depth at which the stress in the chemically strengthened alkali aluminosilicate glass article described herein changes from compressive to tensile. DOC may be measured by FSM or a scattered light polariscope (SCALP) depending on the ion exchange treatment. Where the stress in the glass article is generated by exchanging potassium ions into the glass article, FSM is used to measure DOC. Where the stress is generated by exchanging sodium ions into the glass article, SCALP is used to measure DOC. Where the stress in the glass article is generated by exchanging both potassium and sodium ions into the glass, the DOC is measured by SCALP, since it is believed the exchange depth of sodium indicates the DOC and the exchange depth of potassium ions indicates a change in the magnitude of the compressive stress (but not the change in stress from compressive to tensile); the exchange depth of potassium ions in such glass articles is measured by FSM.

In some embodiments, a strengthened glass-based substrate 120 can have a surface CS of 300 MPa or greater, e.g., 400 MPa or greater, 450 MPa or greater, 500 MPa or greater, 550 MPa or greater, 600 MPa or greater, 650 MPa or greater, 700 MPa or greater, 750 MPa or greater or 800 MPa or greater, and all ranges and sub-ranges between the foregoing values. The strengthened glass-based substrate 120 may have a DOC 15 $\mu$m or greater, 20 $\mu$m or greater (e.g., 25 $\mu$m, 30 $\mu$m, 35 $\mu$m, 40 $\mu$m, 45 $\mu$m, 50 $\mu$m or greater) and/or a central tension of 10 MPa or greater, 20 MPa or greater, 30 MPa or greater, 40 MPa or greater (e.g., 42 MPa, 45 MPa, or 50 MPa or greater) but less than 100 MPa (e.g., 95, 90, 85, 80, 75, 70, 65, 60, 55 MPa or less), and all ranges and sub-ranges between the foregoing values. In one or more specific embodiments, the strengthened glass-based substrate 120 has one or more of the following: a surface CS greater than 500 MPa, a depth of compressive layer greater than 15 $\mu$m, and a central tension greater than 18 MPa.

Without being bound by theory, it is believed that strengthened glass-based substrates 120 with a surface CS greater than 500 MPa and a DOC greater than about 15 $\mu$m typically have greater strain-to-failure than non-strengthened glass-based substrates (or, in other words, glass-based substrates that have not been ion exchanged or otherwise strengthened). In some aspects, the benefits of one or more embodiments described herein may not be as prominent with non-strengthened or weakly strengthened types of glass-based substrates that do not meet these levels of surface CS or DOC, because of the presence of handling or common glass surface damage events in many typical applications. However, as mentioned previously, in other specific applications where the glass-based substrate surfaces can be adequately protected from scratches or surface damage (for example by a protective coating or other layers), strong glass-based substrates with a relatively high strain-to-failure can also be created through forming and protection of a pristine glass surface quality, using methods for example the fusion forming method. In these alternate applications, the benefits of one or more embodiments described herein can be similarly realized.

Example ion-exchangeable glasses that may be used in the strengthened glass-based substrate 120 may include alkali aluminosilicate glass compositions or alkali aluminoborosilicate glass compositions, though other glass compositions are contemplated. As used herein, "ion exchangeable" means that a glass-based substrate is capable of exchanging cations located at or near the surface of the glass-based substrate with cations of the same valence that are either larger or smaller in size. One example glass composition comprises $SiO_2$, $B_2O_3$ and $Na_2O$, where ($SiO_2$ + $B_2O_3$) $\geq$ 66 mol.%, and $Na_2O$ $\geq$ 9 mol.%. In some embodiments, the glass-based substrate 120 includes a glass composition with at least 6 wt.% aluminum oxide. In some embodiments, a glass-based substrate 120 includes a glass composition with one or more alkaline earth oxides, such that a content of alkaline earth oxides is at least 5 wt.%. Suitable glass compositions, in some embodiments, further comprise at least one of $K_2O$, MgO, and CaO. In some embodiments, the glass compositions used in the glass-based substrate 120 can comprise 61-75 mol.% $SiO_2$; 7-15 mol.% $Al_2O_3$; 0-12 mol.% $B_2O_3$; 9-21 mol.% $Na_2O$; 0-4 mol.% $K_2O$; 0-7 mol.% MgO; and 0-3 mol.% CaO.

A further example glass composition suitable for the glass-based substrate 120, which may optionally be strengthened or strong, comprises: 60-70 mol.% $SiO_2$; 6-14 mol.% $Al_2O_3$; 0-15 mol.% $B_2O_3$; 0-15 mol.% $Li_2O$; 0-20 mol.% $Na_2O$; 0-10 mol.% $K_2O$; 0-8 mol.% MgO; 0-10 mol.% CaO; 0-5 mol.% $ZrO_2$; 0-1 mol.% $SnO_2$; 0-1 mol.% $CeO_2$; less than 50 ppm $As_2O_3$; and less than 50 ppm $Sb_2O_3$; where 12 mol.% $\leq$ ($Li_2O$ + $Na_2O$ + $K_2O$) $\leq$ 20 mol.% and 0 mol.% $\leq$ (MgO + CaO) $\leq$ 10 mol.%.

A still further example glass composition suitable for the glass-based substrate 120, which may optionally be strengthened or strong, comprises: 63.5-66.5 mol.% $SiO_2$; 8-12 mol.% $Al_2O_3$; 0-3 mol.% $B_2O_3$; 0-5 mol.% $Li_2O$; 8-18 mol.% $Na_2O$; 0-5 mol.% $K_2O$; 1-7 mol.% MgO; 0-2.5 mol.% CaO; 0-3 mol.% $ZrO_2$; 0.05-0.25 mol.% $SnO_2$; 0.05-0.5 mol.% $CeO_2$; less than 50 ppm $As_2O_3$; and less than 50 ppm $Sb_2O_3$; where 14 mol.% $\leq$ ($Li_2O$ + $Na_2O$ + $K_2O$) $\leq$ 18 mol.% and 2 mol.% $\leq$ (MgO + CaO) $\leq$ 7 mol.%.

In some embodiments, an alkali aluminosilicate glass composition suitable for the glass-based substrate 120, which may optionally be strengthened or strong, comprises alumina, at least one alkali metal and, in some embodiments, greater than 50 mol.% $SiO_2$, in other embodiments at least 58 mol.% $SiO_2$, and in still other embodiments at least 60 mol.% $SiO_2$, all as further defined by the ratio given by Equation (6):

$$\frac{Al_2O_3 + B_2O_3}{\sum \text{modifiers}} > 1 \tag{6}$$

and the components are expressed in mol.% and the modifiers are alkali metal oxides. This glass composition, in particular embodiments, comprises: 58-72 mol.% $SiO_2$; 9-17 mol.% $Al_2O_3$; 2-12 mol.% $B_2O_3$; 8-16 mol.% $Na_2O$; 0-4 mol.% $K_2O$, and as further defined by Equation (6) above.

In some embodiments, the glass-based substrate, which may optionally be strengthened or strong, may include an alkali aluminosilicate glass composition comprising: 64-68 mol.% $SiO_2$; 12-16 mol.% $Na_2O$; 8-12 mol.% $Al_2O_3$; 0-3 mol.% $B_2O_3$; 2-5 mol.% $K_2O$; 4-6 mol.% MgO; and 0-5 mol.% CaO, wherein: 66 mol.% $\leq$ $SiO_2$ + $B_2O_3$ + CaO $\leq$ 69 mol.%;

$Na_2O + K_2O + B_2O_3 + MgO + CaO + SrO > 10$ mol.%; 5 mol.% $\leq$ MgO + CaO + SrO $\leq$ 8 mol.%; $(Na_2O + B_2O_3) - Al_2O_3$ $\leq$ 2 mol.%; 2 mol.% $\leq Na_2O - Al_2O_3 \leq$ 6 mol.%; and 4 mol.% $\leq (Na_2O + K_2O) - Al_2O_3 \leq$ 10 mol.%.

In some embodiments, the glass-based substrate 120, which may optionally be strengthened or strong, may comprise an alkali silicate glass composition comprising: 2 mol% or more of $Al_2O_3$ and/or $ZrO_2$, or 4 mol% or more of $Al_2O_3$ and/or $ZrO_2$.

In some embodiments, the glass-based substrate used in the glass-based substrate 120 may be batched with 0-2 mol% of at least one fining agent selected from a group that includes $Na_2SO_4$, NaCl, NaF, NaBr, $K_2SO_4$, KCl, KF, KBr, and $SnO_2$.

The glass-based substrate 120 according to one or more embodiments can have a thickness 12 ranging from about 50 $\mu$m to 5 mm. Example thicknesses 12 for the glass-based substrate can range from 100 $\mu$m to 500 $\mu$m, e.g., 100, 200, 300, 400 or 500 $\mu$m. Further example thicknesses 12 range from 500 $\mu$m to 1000 $\mu$m, e.g., 500, 600, 700, 800, 900 or 1000 $\mu$m. The glass-based substrate 120 may have a thickness 12 that is greater than 1 mm, e.g., about 2, 3, 4, or 5 mm. In one or more embodiments, the glass-based substrate 120 may have a thickness 12 of 2 mm or less or less than 1 mm. The glass-based substrate 120 may be acid polished or otherwise treated to remove or reduce the effect of surface flaws.

Scratch-resistant Film

The laminate articles 100a, 100b (see FIGS. 1A and 1B) include a scratch-resistant film 110 disposed on a surface of the glass-based substrate 120 and specifically on the crack mitigating layer 130a or stack 130b. The scratch-resistant film 110 may be disposed on one or both major surfaces 122, 124 of the glass-based substrate 120. In one or more embodiments, the film 110 may be disposed on one or more minor surfaces (not shown) of the glass-based substrate 120 in addition to or instead of being disposed on one or both major surfaces 122, 124. In one or more embodiments, the scratch-resistant film 110 is free of macroscopic scratches or defects that are easily visible to the eye. Further, as shown in FIGS. 1A and 1B, the film 110 forms the effective interface 140 with the glass-based substrate 120.

In one or more embodiments, the scratch-resistant film 110 may lower the average flexural strength of laminate articles 100a, 100b incorporating such films and a glass-based substrate, through the mechanisms described herein. In one or more embodiments, such mechanisms include instances in which the film 110 may lower the average flexural strength of the article because crack(s) developing in such film bridge into the glass-based substrate. In other embodiments, the mechanisms include instances in which the film may lower the average flexural strength of the article because cracks developing in the glass-based substrates bridge into the film. The film 110 of one or more embodiments may exhibit a strain-to-failure of 2% or less or a strain-to-failure that is less than the strain to failure of the glass-based substrates described herein. Further, the film 110 of one or more embodiments may exhibit an elastic modulus that is greater than or equal to the elastic modulus of the glass-based substrate 120. Films including one or more of these attributes may be characterized within the disclosure as "brittle."

In accordance with one or more embodiments, the scratch-resistant film 110 may have a strain-to-failure (or crack onset strain level) that is lower than the strain-to-failure of the glass-based substrate 120. For example, the film 110 may have a strain-to-failure of about 2% or less, about 1.8% or less, about 1.6% or less, about 1.5% or less, about 1.4% or less, about 1.2% or less, about 1% or less, about 0.8% or less, about 0.6% or less, about 0.5% or less, about 0.4% or less or about 0.2% or less, and all ranges and sub-ranges between the foregoing values. In some embodiments, the strain-to-failure of the film 110 may be lower than that the strain-to-failure of the strengthened glass-based substrates 120 that have a surface CS greater than 500 MPa and a DOC greater than about 15 $\mu$m. In one or more embodiments, the film 110 may have a strain-to-failure that is at least 0.1% lower or less, or in some cases, at least 0.5% lower or less, and all ranges and sub-ranges between the foregoing values, than the strain-to-failure of the glass-based substrate 120. In one or more embodiments, the film 110 may have a strain-to-failure that is at least about 0.15%, 0.2%, 0.25%, 0.3%, 0.35%, 0.4%, 0.45%, 0.50%, 0.55%, 0.6%, 0.65%, 0.7%, 0.75%, 0.8%, 0.85%, 0.9%, 0.95% or 1% lower or less, and all ranges and sub-ranges between the foregoing values, than the strain-to-failure of the glass-based substrate 120. These strain-to-failure values are measured using ring-on-ring flexural test methods combined with optional microscopic or high-speed-camera analysis. The onset of film cracking may be measured by analyzing the electrical resistivity of a conducting film. If the film is electrically conducting, or a thin electrically conducting film is applied onto the sample, the electrical conductivity can be used to measure strain-to-failure. The strain to failure can be measured by monitoring the sample during the test, for example using a camera or electrical measurement, or by inspecting the sample after the load is applied and removed, for example looking for evidence of cracking optically or electrically after removing the load from the sample. These various strain-to-failure analyses can be performed during the application of load or stress, or in some cases after the application of load or stress.

Exemplary scratch-resistant films 110 may have an elastic modulus of at least 25 GPa and/or a hardness of at least 1.75 GPa, although some combinations outside of this range are possible. In some embodiments the scratch-resistant film 110 may have an elastic modulus of 50 GPa or greater or even 70 GPa or greater, and all ranges and sub-ranges between the foregoing values. For example, the film elastic modulus may be 55 GPa, 60 GPa, 65 GPa, 75 GPa, 80 GPa, 85 GPa or more, and all ranges and sub-ranges between the foregoing values. In one or more embodiments, the film 110 may have a hardness greater than 3.0 GPa. For example, the film 110 may have a hardness of 5 GPa, 5.5 GPa, 6 GPa, 6.5 GPa, 7 GPa, 7.5 GPa, 8 GPa, 8.5 GPa, 9 GPa, 9.5 GPa, 10 GPa, 11 GPa, 12 GPa, 13 GPa, 14 GPa, 15 GPa, 16 GPa or greater, and all ranges and sub-ranges between the foregoing values. These elastic modulus and hardness values measured for such films 110 were done using known diamond nano-indentation methods, as described above, with a Berkovich diamond indenter tip.

The scratch-resistant films 110 described herein may also exhibit a fracture toughness of less than about 10 $MPa \cdot m^{1/2}$, or in some cases less than 5 $MPa \cdot m^{1/2}$, or in some cases less than 1 $MPa \cdot m^{1/2}$. For example, the film may have a fracture toughness of 4.5 $MPa \cdot m^{1/2}$, 4 $MPa \cdot m^{1/2}$, 3.5 $MPa \cdot m^{1/2}$, 3 $MPa \cdot m^{1/2}$, 2.5 $MPa \cdot m^{1/2}$, 2 $MPa \cdot m^{1/2}$, 1.5 $MPa \cdot m^{1/2}$, 1.4 $MPa \cdot m^{1/2}$, 1.3 $MPa \cdot m^{1/2}$, 1.2 $MPa \cdot m^{1/2}$, 1.1 $MPa \cdot m^{1/2}$, 0.9 $MPa \cdot m^{1/2}$, 0.8 $MPa \cdot m^{1/2}$, 0.7 $MPa \cdot m^{1/2}$, 0.6 $MPa \cdot m^{1/2}$, 0.5 $MPa \cdot m^{1/2}$, 0.4 $MPa \cdot m^{1/2}$, 0.3 $MPa \cdot m^{1/2}$, 0.2 $MPa \cdot m^{1/2}$, 0.1 $MPa \cdot m^{1/2}$ or less, and all ranges and sub-ranges between the foregoing values.

The scratch-resistant films 110 described herein may also have a critical strain energy release rate ($G_{IC} = K_{IC}^2/E$) that is less than about 0.1 $kJ/m^2$, or in some cases less than 0.01 $kJ/m^2$. In one or more embodiments, the film 110 may have a critical strain energy release rate of 0.09 $kJ/m^2$, 0.08 $kJ/m^2$, 0.07 $kJ/m^2$, 0.06 $kJ/m^2$, 0.05 $kJ/m^2$, 0.04 $kJ/m^2$, 0.03 $kJ/m^2$, 0.02 $kJ/m^2$, 0.01 $kJ/m^2$, 0.0075 $kJ/m^2$, 0.005 $kJ/m^2$, 0.0025 $kJ/m^2$ or less, and all ranges and sub-ranges between the foregoing values.

In one or more embodiments, the scratch-resistant film 110 may include a plurality of layers, each with the same or with different thicknesses. In certain aspects, one or more layers within the film 110 may have a different composition than the other layers in film 110. Various sequences of layers making up film 110 are also contemplated by certain aspects of the disclosure. In one or more embodiments, each of the layers of the film may be characterized as brittle based on one or more of the layer's impact on the average flexural strength of the laminate article 100a, 100b and/or the layer's strain-to-failure, fracture toughness, elastic modulus, or critical strain energy release rate values, as otherwise described herein. In one variant, the layers of the scratch-resistant film 110 need not have identical properties for example elastic modulus and/or fracture toughness. In another variant, the layers of the film 110 may include different materials from one another - e.g., as in alternating, thin layers having different compositions. In some embodiments, the scratch-resistant film 110 includes an outermost layer or layers with high scratch resistance (e.g., a silicon nitride layer) and an innermost layer or layers with other functional properties (e.g., a conducting film comprising a transparent conductive oxide for example ITO).

The compositions or material(s) of the scratch-resistant film 110 are limited in the sense that the bulk of the film 110, or at least its outermost layer or layers, should exhibit an appropriate level of scratch resistance for the application of the article 100a, 100b. The scratch-resistant film 110 comprises at least one of a metal-containing oxide, a metal-containing oxynitride, a metal-containing nitride, a metal-containing carbide, a silicon-containing polymer, a carbon, a semiconductor, and combinations thereof. Examples of the scratch-resistant film 110 materials include oxides for example $SiO_2$, $Al_2O_3$, $TiO_2$, $Nb_2O_5$, $Ta_2O_5$; oxynitrides for example $SiO_xN_y$, $Si_uAl_xO_yN_z$, and $AlO_xN_y$; nitrides for example $SiN_x$, $AlN_x$, cubic boron nitride, and $TiN_x$; carbides for example SiC, TiC, and WC; combinations of the above for example oxycarbides and oxy-carbo-nitrides (for example, $SiC_xO_y$ and $SiC_xO_yN_z$); semiconductor materials for example Si and Ge; transparent conductors for example indium-tin-oxide (ITO), tin oxide, fluorinated tin oxide, aluminum zinc oxide, or zinc oxide; carbon nanotube or graphene-doped oxides; silver or other metal-doped oxides, highly siliceous polymers for example highly cured siloxanes and silsesquioxanes; diamond or diamond-like-carbon materials; or selected metal films which can exhibit a fracture behavior. Further, for those scratch-resistant films 110 containing layer or layers with materials not typically associated with high scratch resistance (e.g., semiconductor materials, cubic boron nitride, etc.), the outermost layer or layers of the scratch-resistant film can comprise a metal-containing oxide, a metal-containing oxynitride, a metal-containing nitride, a metal-containing carbide, a silicon-containing polymer, a diamond-like carbon material, and combinations thereof. In addition, various multilayer scratch-resistant coating designs described in U.S. Patent Nos. 9,079,802, 9,355,444, 9,359,261, and 9,366,784, can also be employed in the laminate articles and thereby obtain the benefit of the crack mitigating layer schemes of the disclosure.

The scratch-resistant film 110 can be disposed on the glass-based substrate 120 by vacuum deposition techniques, for example, chemical vapor deposition (e.g., plasma enhanced chemical vapor deposition, atmospheric pressure chemical vapor deposition, or plasma-enhanced atmospheric pressure chemical vapor deposition), physical vapor deposition (e.g., reactive or nonreactive sputtering or laser ablation), thermal, resistive, or e-beam evaporation, or atomic layer deposition. The scratch-resistant film 110 may also be disposed on one or more surfaces 122, 124 of the glass-based substrate 120 using liquid-based techniques, for example sol-gel coating or polymer coating methods, for example spin, spray, slot draw, slide, wire-wound rod, blade/knife, air knife, curtain, gravure, and roller coating among others. In some embodiments it may be desirable to use adhesion promoters, for example silane-based materials, between the scratch-resistant film 110 and the glass-based substrate 120, between the glass-based substrate 120 and crack mitigating layer 130a or stack 130b, between the layers (if any) of the crack mitigating layer 130a or stack 130b, between the layers (if any) of the film 110 and/or between the film 110 and the crack mitigating layer 130a or stack 130b. In one or more alternative embodiments, the scratch-resistant film 110 may be disposed directly on the glass-based substrate 120, or formed as a separate layer and then bonded thereto.

The thickness 11 of the scratch-resistant film 110 (see FIGS. 1A and 1B) can vary depending on the intended use of the laminate article 100a, 100b. In some embodiments the scratch-resistant film 110, thickness 11 may be in the ranges from about 0.005 $\mu$m to about 0.5 $\mu$m or from about 0.01 $\mu$m to about 20 $\mu$m. In come embodiments, the film 110 may have a thickness 11 in the range from about 0.05 $\mu$m to about 10 $\mu$m, from about 0.05 $\mu$m to about 0.5 $\mu$m, from about 0.01 $\mu$m to about 0.15 $\mu$m or from about 0.015 $\mu$m to about 0.2 $\mu$m, and all ranges and sub-ranges between the foregoing values.

In some embodiments, it may be advantageous to include a material (or materials) in the scratch-resistant film 110 (e.g., as comprising a single layer, dual-layer or multi-layer structure) that has:

(1) a refractive index that is similar to (or greater than) the refractive index of either the glass-based substrate 120, the crack mitigating layer 130a or stack 130b and/or other films or layers in order to minimize optical interference effects;

(2) a refractive index (real and/or imaginary components) that is tuned to achieve anti-reflective interference effects; and/or

(3) a refractive index (real and/or imaginary components) that is tuned to achieve wavelength-selective reflective or wavelength-selective absorptive effects, for example to achieve UV or IR blocking or reflection, or to achieve coloring/tinting effects.

In one or more embodiments, the scratch-resistant film 110 may have a refractive index that is greater than the refractive index of the glass-based substrate 120 and/or greater than the refractive index of the crack mitigating layer 130a or stack 130b. In one or more embodiments, the film 110 may have a refractive index in the range from about 1.7 to about 2.2, or in the range from about 1.4 to about 1.6, or in the range from about 1.6 to about 1.9, and all ranges and sub-ranges between the foregoing values. Some embodiments can employ a film 110 having one or more layers in which such layer(s) have a refractive index comparable to that of the substrate, even if the aggregate refractive index of the film exceeds that of the substrate (e.g., a film 110 with one or more silica layers and a balance of silicon nitride layer(s) disposed over a substrate 120 having a silicate glass composition).

The scratch-resistant film 110 may also serve multiple functions, or be integrated with additional film(s) or layers as described herein that serve other functions than the scratch-resistance associated with the scratch-resistant film 110. For example, the scratch-resistant film 110 may include UV or IR light reflecting or absorbing layers, anti-reflection layers, anti-glare layers, dirt-resistant layers, self-cleaning layers, scratch-resistant layers, barrier layers, passivation layers, hermetic layers, diffusion-blocking layers, fingerprint-resistant layers, and the like. Further, the film 110 may include conducting or semiconducting layers, thin film transistor layers, EMI shielding layers, breakage sensors, alarm sensors, electrochromic materials, photochromic materials, touch sensing layers, or information display layers. The film 110 and/or any of the foregoing layers may include colorants or tint. When information display layers are integrated into the laminate article 100a, 100b, the article may form part of a touch-sensitive display, a transparent display, or a heads-up display. In such cases, it may be desirable that the scratch-resistant film 110 performs an interference function, which selectively transmits, reflects, or absorbs different wavelengths or colors of light. For example, the scratch-resistant film 110 may selectively reflect a targeted wavelength in a heads-up display application.

Other functional properties of the scratch-resistant film 110 besides scratch resistance include optical properties, electrical properties and/or mechanical properties, for example hardness, elastic modulus, strain-to-failure, abrasion resistance, mechanical durability, coefficient of friction, electrical conductivity, electrical resistivity, electron mobility, electron or hole carrier doping, optical refractive index, density, opacity, transparency, reflectivity, absorptivity, transmissivity and the like. These functional properties are substantially maintained or even improved after the scratch-resistant film 110 is combined with the glass-based substrate 120, crack mitigating layer 130a or stack 130b and/or other films included in the article 100a, 100b.

Crack Mitigating Layer and Crack Mitigating Stack

As described herein, the crack mitigating layer 130a or stack 130b (see FIGS. 1A and 1B) provides a moderate adhesion energy at the effective interface 140 in laminate articles 100a, 100b. The crack mitigating layer 130a and stack 130b provide a moderate adhesion energy by forming a low toughness layer at the effective interface 140 that facilitates crack deflection into the crack mitigating layer/stack instead of into the scratch-resistant film 110 or glass-based substrate 120. The crack mitigating layer 130a or stack 130b may also provide a moderate adhesion energy value by forming a low toughness interface. The low toughness interface is characterized by delamination of the crack mitigating layer 130a or stack 130b from the glass-based substrate 120 or scratch-resistant film 110 upon application of a specified load. This delamination causes cracks to deflect along either the first interface 150 or the second interface 160 (e.g., for laminate articles 100a, 100b when a scratch-resistant film 110 is present over the crack mitigating layer 130a or stack 130b).

In one or more embodiments, crack mitigating stack 130b provides moderate adhesion by modifying the effective adhesion energy at the effective interface 140, e.g., between the glass-based substrate 120 and the scratch-resistant film 110 for articles 100a, 100b. In one or more specific embodiments, one or both of the first interface 150 and the second interface 160 exhibit the effective adhesion energy. In one or more embodiments, the effective adhesion energy of these interfaces may be about 5 $J/m^2$ or less, about 4.5 $J/m^2$ or less, about 4 $J/m^2$ or less, about 3.5 $J/m^2$ or less, about 3 $J/m^2$ or less, about 2.5 $J/m^2$ or less, about 2 $J/m^2$ or less, about 1.5 $J/m^2$ or less, about 1 $J/m^2$ or less or about 0.85 $J/m^2$ or less, and all ranges and sub-ranges between the foregoing values. The lower limit of the effective adhesion energy may be about 0.1 $J/m^2$ or about 0.01 $J/m^2$. In one or more embodiments, the effective adhesion energy at one or more of the first interface and the second interface may be in the range from about 0.85 $J/m^2$ to about 3.85 $J/m^2$, from about 0.85 $J/m^2$ to about 3 $J/m^2$, from about 0.85 $J/m^2$ to about 2 $J/m^2$, and from about 0.85 $J/m^2$ to about 1 $J/m^2$, and all ranges and sub-ranges between the foregoing values. The effective adhesion energy at one or more of the first interface 150 and the second interface 160 can also be from about 0.1 $J/m^2$ to about 0.85 $J/m^2$, or from about 0.3 $J/m^2$ to about 0.7 $J/m^2$, and all ranges and sub-ranges between the foregoing values. According to some embodiments, the effective adhesion energy at one or more of the first interface and the second interface remains substantially constant, or within a target range for example from 0.1 $J/m^2$ and about 0.85 $J/m^2$, from ambient temperature up to about 600°C. In some embodiments, the effective adhesion energy at one or more of the interfaces is at least 25% less than the average cohesive adhesion energy of the glass-based substrate from ambient temperature up to about 600°C.

In embodiments of laminate articles 100a, 100b (see FIGS. 1A and 1B) in which the effective interface 140, the first interface 150 and/or the second interface 160 exhibits moderate adhesion, at least a portion of the crack mitigating stack 130b may separate from the glass-based substrate 120 and/or the scratch-resistant film 110 during a loading process that causes crack growth and/or crack formation in the film and/or the crack mitigating layer or stack. When at least a portion of the crack mitigating stack 130b separates from the glass-based substrate 120 and/or the film 110, such separation may include a reduced adhesion or no adhesion between the crack mitigating layer and the glass-based substrate 120 and/or film 110 from which the crack mitigating layer or stack separates. In other embodiments, when a portion of the crack mitigating stack separates, such a separated portion may be surrounded completely or at least partially by portions of the crack mitigating stack still adhered to the glass-based substrate 120 and/or film 110. In one or more embodiments, at least a portion of the crack mitigating stack 130b may separate from one of the film 110 or the glass-based substrate 120 when the laminated article is strained at a specified strain level during such loading. In one or more embodiments, the strain level may be between the first average strain-to-failure of the glass-based substrate 120 and the average strain-to-failure of the scratch-resistant film 110.

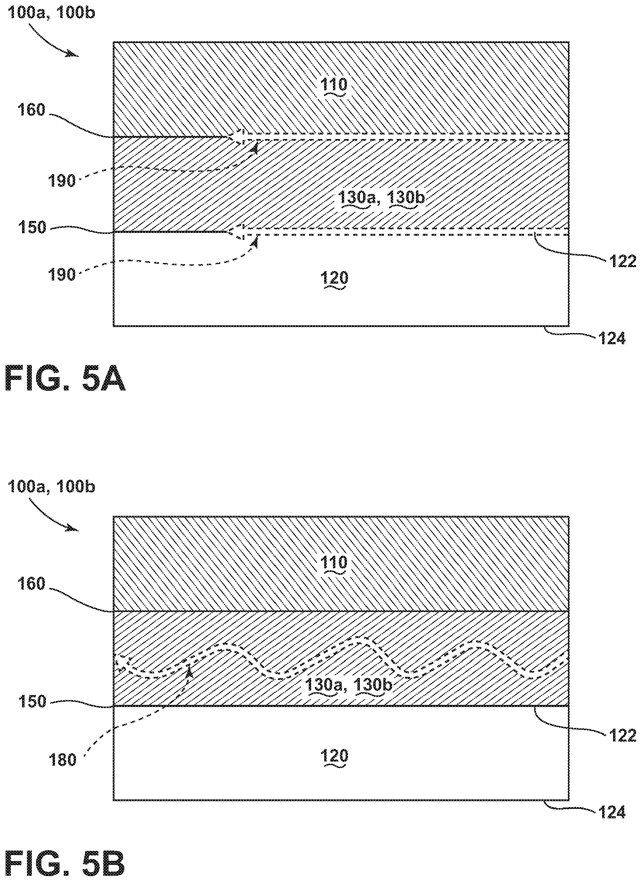

In one or more specific embodiments of laminate articles 100a, 100b, at least a portion of the crack mitigating stack 130b separates from the scratch-resistant film 110 when a crack originating in the film 110 bridges into the crack mitigating stack 130b (or crosses the second interface 160). In some embodiments of the article 100a, 100b, at least a portion of the crack mitigating stack 130b separates from the film 110 as an adhesive failure 190 at the interface 160 (see FIG. 5A) when a crack originating in the film 110 bridges into the crack mitigating stack 130b. In some embodiments, at least a portion of the crack mitigating stack 130b separates from the glass-based substrate 120 as an adhesive failure 190 at the interface 150 (see FIG. 5A) when a crack originating in the glass-based substrate 120 bridges into the crack mitigating layer stack 130b. As used herein, the term "adhesive failure" relates to crack propagation substantially confined to one or more of the interfaces 150 and 160 between the crack mitigating stack 130b, the scratch-resistant film 110 and the glass-based substrate 120 of the articles 100a, 100b.

The crack mitigating stack 130b does not separate and remains adhered to the glass-based substrate 120 and the scratch-resistant film 110 for articles 100a, 100b at load levels that do not cause crack growth and/or crack formation (i.e., at average strain-to-failure levels less than the average strain-to-failure of the glass-based substrate and less than the average strain-to-failure of the film). Without being bound by theory, delamination or partial delamination of the crack mitigating stack 130b reduces the stress concentrations in the glass-based substrate 120. Accordingly, it is believed that a reduction in stress concentrations in the glass-based substrate 120 causes an increase in the load or strain level that causes the glass-based substrate 120 (and ultimately the laminated articles 100a, 100b) to fail. In this manner, the crack mitigating stack 130b prevents a decrease of, or increases, the average flexural strength of the laminated article, as compared to laminated articles without the crack mitigating layer.

The material and thickness of the crack mitigating stack 130b can be used to control the effective adhesion energy between glass-based substrate 120 and/or the scratch-resistant film 110. In general, the adhesion energy between two surfaces is given by (see L. A. Girifalco and R. J. Good, "A theory for the estimation of surface and interfacial energies, I. derivation and application to interfacial tension," Journal of Physical Chemistry, vol. 61, p. 904 ("Girifalco and Good")):

$$W = \gamma_1 + \gamma_2 - \gamma_{12} \tag{7}$$

where $\gamma_1$, $\gamma_2$ and $\gamma_{12}$ are the surface energies of surface 1, surface 2 and the interfacial energy of surface 1 and 2 respectively. The individual surface energies are usually a combination of two terms: a dispersion component $\gamma^d$ and a polar component $\gamma^p$ given by:

$$\gamma = \gamma^d + \gamma^p \tag{8}$$

When the adhesion is mostly due to London dispersion forces ($\gamma^d$) and polar forces for example hydrogen bonding ($\gamma^p$), the interfacial energy could be given by (*see* Girifalco and Good):

$$\gamma_{12} = \gamma_1 + \gamma_2 - 2\sqrt{\gamma_1{}^d \gamma_2{}^d} - 2\sqrt{\gamma_1{}^p \gamma_2{}^p} \tag{9}$$

After substituting (9) in (7), the energy of adhesion could be approximately calculated as:

$$W \sim 2\left[\sqrt{\gamma_1{}^d \gamma_2{}^d} + \sqrt{\gamma_1{}^p \gamma_2{}^p}\right] \tag{10}$$

In the above equation (10), only van der Waal (and/or hydrogen bonding) components of adhesion energies are considered. These include polar-polar interaction (Keesom), polar-non polar interaction (Debye) and nonpolar-nonpolar interaction (London). However, other attractive energies may also be present, for example covalent bonding and electrostatic bonding. So, in a more generalized form, the above equation is written as:

$$W \sim 2\left[\sqrt{\gamma_1{}^d \gamma_2{}^d} + \sqrt{\gamma_1{}^p \gamma_2{}^p}\right] + w_c + w_e \tag{11}$$

where $w_c$ and $w_e$ are the covalent and electrostatic adhesion energies. Equation (11) describes that the adhesion energy is a function of four surface energy parameters plus the covalent and electrostatic energy, if any. An appropriate adhesion energy can be achieved by choice of crack mitigating stack 130b material(s) to control van der Waals (and/or hydrogen) bonding and/or covalent bonding.

The adhesive energy of thin films is challenging to directly measure, including the adhesive energy between the crack mitigating stack 130b and the glass-based substrate 120 or scratch-resistant film 110. In contrast, the bond strength of the bond between two pieces of glass can be determined by inserting a thin blade and measuring the crack length. In the case of a first glass bonded to a second glass with a coating or surface modification, the bond adhesion energy $\gamma$ is related to the first glass Young's modulus $E_1$, first glass thickness $t_{w1}$, second glass modulus $E_2$, second glass thickness $t_{w2}$, blade thickness $t_b$, and crack length L by the following equation, given by Equation (12) below.

$$\gamma = \frac{3t_b^2 E_1 t_{w1}^3 E_2 t_{w2}^3}{16L^4(E_1 t_{w1}^3 + E_2 t_{w2}^3)} \tag{12}$$

Equation (12) can be employed to approximate the adhesive energy between the crack mitigating layer stack 130b and the glass-based substrate 120 or scratch-resistant film 110. Equation (12) can also be employed to estimate the adhesive energy at the interfaces 150 and 160, respectively, for laminate articles 100a, 100b depicted in FIGS. 1A and 1B. For example, the adhesive energy between two glass-based substrates (e.g., one thick and one thin) can be measured using Equation (12) as a control. Various glass-based substrate samples can then be prepared by conducting a surface treatment to a control glass-based substrate bonding (e.g., between a first glass-based substrate and a second glass-based substrate). The surface treatment is exemplary of a particular crack mitigating stack 130b structure. After the surface treatment, the treated glass-based substrate is then bonded to a second glass-based substrate comparable to the second substrates employed as the control. The adhesive energy for the treated samples can then be measured using Equation (12) and then compared to the results obtained from comparable measurements to the glass control samples.

In one or more embodiments of the laminated articles 100a and 100b depicted in FIGS. 1A and 1B, the crack mitigating stack 130b may form a preferred path of crack propagation other than bridging between the scratch-resistant film 110 and the glass-based substrate 120. In other words, the crack mitigating stack 130b may deflect a crack, forming in one of the film 110 and the glass-based substrate 120 and propagating toward the other of the film 110 and the glass-based substrate 120, into the crack mitigating stack 130b. In such embodiments, the crack may propagate through the crack mitigating stack 130b in a direction substantially parallel to at least one of the first interface 150 or the second interface 160 for laminate articles 100a, 100b. As depicted in FIG. 5B, the crack becomes a cohesive failure 180, when confined within the crack mitigating stack 130b. As used herein, the term "cohesive failure" relates to crack propagation substantially confined within the crack mitigating stack 130b.

The crack mitigating stack 130b, when configured to develop a cohesive failure 180 as shown in FIG. 5B, provides a preferred path for crack propagation in such embodiments. The crack mitigating stack 130b may cause a crack originating in the scratch-resistant film 110 or the glass-based substrate 120 and entering into the crack mitigating stack 130b to remain in the crack mitigating layer. Alternatively, or additionally, the crack mitigating stack 130b of laminate articles 100b effectively confines a crack originating in one of the scratch-resistant film 110 and glass-based substrate 120 from propagating into the other of such film and glass-based substrate. Similarly, the crack mitigating stack 130b of laminate article 100b effectively confines a crack originating in the stack 130b and glass-based substrate 120 from propagating into the other such layer and substrate. These behaviors may be characterized individually or collectively as crack deflection. In this way, the crack is deflected from bridging between the film 110 and the glass-based substrate 120, or between the crack mitigating stack 130b and the glass-based substrate 120. In one or more embodiments, the crack mitigating stack 130b may provide a low toughness layer or interface that exhibits a low fracture toughness and/or a low critical strain energy release rate, which may promote crack deflection into the crack mitigating stack 130b instead of through the crack mitigating layer into the film 110 and/or glass-based substrate 120. As used herein, "facilitate" includes creating favorable conditions in which the crack deflects into the crack mitigating stack 130b instead of propagating into the glass-based substrate 120 or the film 110. The term "facilitate" may also include creating a less tortuous path for crack propagation into and/or through the crack mitigating stack 130b instead of into the glass-based substrate 120 or the film 110.

The crack mitigating stack 130b may exhibit a relatively low fracture toughness to provide a low toughness crack mitigating layer, as will be described in greater detail below. In such embodiments, the crack mitigating stack 130b may exhibit a fracture toughness that is about 50% or less than 50% of the fracture toughness of either the glass-based substrate 120 or the scratch-resistant film 110. In more specific embodiments, the fracture toughness of the crack mitigating stack 130b may be about 25% or less than 25% of the fracture toughness of either the glass-based substrate 120 or the film 110. For example, the crack mitigating layer 130a or stack 130b may exhibit a fracture toughness of about 1 MPa·m$^{1/2}$ or less, 0.75 MPa·m$^{1/2}$ or less, 0.5 MPa·m$^{1/2}$ or less, 0.4 MPa·m$^{1/2}$ or less, 0.3 MPa·m$^{1/2}$ or less, 0.25 MPa·m$^{1/2}$ or less, 0.2 MPa·m$^{1/2}$ or less, 0.1 MPa·m$^{1/2}$ or less, and all ranges and sub-ranges between the foregoing values.

In accordance with one or more embodiments of the article 100b, the crack mitigating stack 130b may have an average strain-to-failure that is greater than the average strain-to-failure of the scratch-resistant film 110. In one or more embodiments of laminate article 100b, the crack mitigating stack 130b may have an average strain-to-failure that is equal to or greater than about 0.5%, 0.7%, 1%, 1.5%, 2%, or even 4%. The crack mitigating stack 130b may have an average strain-to-failure of 0.6%, 0.8%, 0.9%, 1.1%, 1.2%, 1.3%, 1.4%, 1.5%, 1.6%, 1.7%, 1.8%, 1.9%, 2.0% 2.2%, 2.4%, 2.6%, 2.8%, 3%, 3.2%, 3.4%, 3.6%, 3.8%, 4%, 5% or 6% or greater, and all ranges and sub-ranges between the foregoing values. In one or more embodiments, the scratch-resistant film 110 may have an average strain-to-failure (crack onset strain) that is 1.5%, 1.0%, 0.7%, 0.5%, or even 0.4% or less, and all ranges and sub-ranges between the foregoing values. The film 110 may have an average strain-to-failure of 1.4%, 1.3%, 1.2%, 1.1%, 0.9%, 0.8%, 0.6%, 0.3%, 0.2%, 0.1% or less, and all ranges and sub-ranges between the foregoing values. The average strain-to-failure of the glass-based substrate 120 may be greater than the average strain-to-failure of the scratch-resistant film 110 for laminate articles 100a, 100b, and in some instances, may be greater than the average strain-to-failure of the crack mitigating stack 130b. In some other specific embodiments of laminated articles 100a and 100b, the crack mitigating stack 130b may have a higher average strain-to-failure than the glass-based substrate 120, to minimize any negative mechanical effect of the crack mitigating layer on the glass-based substrate.

The crack mitigating stack 130b according to one or more embodiments may have a critical strain energy release rate ($G_{IC} = K_{IC}^2/E$) that is greater than the critical strain energy release rate of the scratch-resistant film 110. In other examples, the crack mitigating stack 130b may exhibit a critical strain energy release rate that is less than 0.25 times or less than 0.5 times the critical strain energy release rate of the glass-based substrate. In specific embodiments, the critical strain energy release rate of the crack mitigating layer 130 can be about 0.1 kJ/m$^2$ or less, about 0.09 kJ/m$^2$ or less, about 0.08 kJ/m$^2$ or less, about 0.07 kJ/m$^2$ or less, about 0.06 kJ/m$^2$ or less, about 0.05 kJ/m$^2$ or less, about 0.04 kJ/m$^2$ or less, about 0.03 kJ/m$^2$ or less, about 0.02 kJ/m$^2$ or less, about 0.01 kJ/m$^2$ or less, about 0.005 kJ/m$^2$ or less, about 0.003 kJ/m$^2$ or less, about 0.002 kJ/m$^2$ or less, about 0.001 kJ/m$^2$ or less; but in some embodiments, greater than about 0.0001 kJ/m$^2$ (i.e., greater than about 0.1 J/m$^2$), and all ranges and sub-ranges between the foregoing values.

The crack mitigating stack 130b employed in laminate article 100b may have a refractive index that is greater than the refractive index of the glass-based substrate 120. In one or more embodiments, the refractive index of the crack mitigating stack 130b may be less than the refractive index of the scratch-resistant film 110. In some embodiments, the refractive index of the crack mitigating stack 130b may be between the refractive index of the glass-based substrate 120 and the film 110. For example, the refractive index of the crack mitigating stack 130b may be in the range from about 1.45 to about 1.95, from about 1.5 to about 1.8, or from about 1.6 to about 1.75, and all ranges and sub-ranges between the foregoing values.. Alternatively, the crack mitigating stack may have a refractive index that is substantially the same as the glass-based substrate, or a refractive index that is not more than 0.05 index units greater than or less than that of the glass-based substrate over a substantial portion of the visible wavelength range (e.g. from 450 to 650 nm). In certain implementations, the crack mitigating stack 130b is configured such that the optical transmittance of the substrate and the crack mitigating layer vary by 1% or less from the optical transmittance of the substrate alone. Put another way, the crack mitigating stack 130b can be configured such that the optical properties (e.g., optical transmittance and reflectance) of the substrate are retained.

In one or more embodiments, the crack mitigating stack 130b of the laminate article 100b is able to withstand high temperature processes. Such processes can include vacuum deposition processes for example chemical vapor deposition (e.g., plasma-enhanced chemical vapor deposition), physical vapor deposition (e.g., reactive or nonreactive sputtering or laser ablation), thermal or e-beam evaporation and/or atomic layer deposition. In one or more specific embodiments, the crack mitigating stack 130b is able to withstand a vacuum deposition process in which the scratch-resistant film 110 and/or other films disposed on the glass-based substrate 120 are deposited on the crack mitigating stack 130b via vacuum deposition. As used herein, the term "withstand" includes the resistance of the crack mitigating stack 130b to temperatures exceeding 100 °C, 200 °C, 300 °C, 400 °C, 500 °C, 600 °C and potentially even greater temperatures, i.e., the layer can be subjected to these temperatures without degrading or undergoing a major change in properties. In some embodiments, the crack mitigating layer stack 130b may be considered to withstand the vacuum deposition or temperature treatment process if the crack mitigating layer 130a or stack 130b experiences a weight loss of 10% or less, 8% or less, 6% or less, 4% or less, 2% or less or 1% or less, and all ranges and sub-ranges between the foregoing values, after deposition of the film 110 and/or other films on the glass-based substrate (and on the crack mitigating stack 130b). The deposition process (or testing after the deposition process) under which the crack mitigating layer experiences weight loss can include temperatures of about 100 °C or greater, 200 °C or greater, 300 °C or greater, 400 °C or greater; environments that are rich in a specific gas (e.g., oxygen, nitrogen, argon etc.); and/or environments in which deposition may be performed under high vacuum (e.g. 133.322•10$^{-6}$ Pa (10$^{-6}$ Torr)), under atmospheric conditions and/or at pressures therebetween (e.g., 1.33322 Pa (10 mTorr)). As will be discussed herein, the material utilized to form the crack mitigating stack 130b may be specifically selected for its high temperature tolerance (i.e., the ability to withstand high temperature processes for example vacuum deposition processes) and/or its environmental tolerance (i.e., the ability to withstand environments rich in a specific gas or at a specific pressure). These tolerances may include high temperature tolerance, high vacuum tolerance, low vacuum outgassing, a high tolerance to plasma or ionized gases, a high tolerance to ozone, a high tolerance to UV, a high tolerance to solvents, or a high tolerance to acids or bases. In some instances, the crack mitigating stack 130b may be selected to pass an outgassing test according to ASTM E595. In one or more embodiments, the laminate article 100a, 100b including the crack mitigating stack 130b may exhibit an improved average flexural strength over articles without the crack mitigating stack 130b. In other words, articles 100a, 100b that include a glass-based substrate 120, a scratch-resistant film 110 and a crack mitigating stack 130b can exhibit greater average flexural strength than similar articles that include the glass-based substrate 120 and the scratch-resistant film 110 but no crack mitigating stack 130b.

In one or more aspects of the disclosure (outside the scope of the claims), the crack mitigating layer 130a (see FIG. 1A) may include an organosilicate or organosilicon material, which can be deposited by atmospheric plasma chemical vapor deposition (APCVD), plasma-enhanced chemical vapor deposition (PECVD), low pressure chemical vapor deposition (LPCVD) or spin-on-glass (SOG) processing techniques. In certain aspects, the organosilicate material or organosilicon material is derived from a methylated silica. In some aspects, the organosilicate materials are characterized by a siloxane network with an average silicon connectivity of less than four where each silicon atom on average has some non-zero probability of being directly bonded with up to three organic groups. Typically, such materials are formed by a reaction of mono-, di- or tri-functional organosilicon compounds, optionally with other additions for example silicon precursors and oxidizers. In some aspects, these organosilicate or organosilicon materials are derived from any one of the following organometal precursors: hexamethyldisiloxane (HMDSO), hexamethyldislazane (HMDSN), tetraethylorthosilicate (TEOS), tetramethyldisoloxane (TMDSO), and tetrahethylsilane (TMS). Some aspects of the disclosure involve the development of an organosilicate or organosilicon material for use as the crack mitigating layer 130a using an organoaluminum precursor. In addition, the properties of the crack mitigating layer 130a for example elastic modulus, porosity, surface roughness and adhesion (e.g., between the scratch-resistant film 110 and the glass-based substrate 120) can be tuned by adjusting one or more of the following parameters when a plasma-enhanced chemical vapor deposition technique is employed to develop the layer 130a: plasma source frequency and power, working and carry gas flow rate, precursor flow rate, the presence of an oxygen gas, precursor species, the distance between the plasma source and substrate, etc. For PECVD and LPCVD processes, the foregoing parameters can be adjusted to tune the properties of the crack mitigating layer 130a along with chamber pressure, vacuum levels, etc., giving these process methods some additional flexibility.

The organic substitution, i.e., a methyl group quantity that is incorporated into the Si-O-Si backbone structure, in these materials employed in the composition for the crack mitigating layer 130a (see FIG. 1A) has several advantages of interest. For example, the organic group can lower the surface energy of the silicate with increasing organic substitution from a value near glass (i.e., -75 mJ/m$^2$ as measured by contact angle with deionized water, hexadecane, and diiodomethane and calculated by the Wu equation, discussed below) to a value near 35 mJ/m$^2$, a value more typical of polymeric materials. Another advantage of the organic substitution is that it can lower the elastic modulus of the material by decreasing its network density, decreasing the polarity of the Si-O-Si bonds, and increasing molar free volume. A further advantage of organic substitution is that it raises the refractive index of the silicate with increasing organic fractions.

In certain aspects of the disclosure (outside the scope of the claims), the crack mitigating layer 130a (see FIG. 1A) comprising an organosilicate employed in the laminate article 100a can be fabricated with vapor deposition process (e.g., APCVD, PECVD, ACVD) or an SOG process using a TMS precursor and a working gas (e.g., argon, helium and combinations thereof). Advantageously, oxygen gas can be introduced into the deposition or processing chamber to facilitate the formation of a Si-O-Si backbone in the resultant crack mitigation layer 130a. Without being bound by theory, it is believed that higher percentages of Si-O-Si backbones in the crack mitigating layer 130a will improve the strength of the coating, reducing the likelihood of cohesive failures (e.g., a cohesive failure 180 as shown in FIG. 5B) at application-related load levels applied to the laminate article 100a. As the likelihood of cohesive failures is decreased and the strength of the layer 130a is increased, the scratch resistance of the scratch-resistant film 110 of a laminate article 100a containing such a crack mitigating layer 130a will be increased. In certain implementations of vapor deposition processes to fabricate the crack mitigating layer 130a comprising an organosilicate, the TMS flow rate is controlled from about 20 sscm to 100 sccm, and preferably from 25 to 60 sccm. At the same time, oxygen gas is introduced at from 50 to 200 sccm, preferably from 100 to 150 sccm.

In further aspects of the disclosure (outside the scope of the claims), the crack mitigating layer 130a (see FIG. 1A) comprising an organosilicate can be fabricated with vapor deposition process using a TMS precursor and oxygen gas ($O_2$). More particularly, the ratio of TMS gas to $O_2$ gas can be controlled to adjust the elastic modulus of the crack mitigating layer 130a. Without being bound by theory, higher percentages of carbon and hydrogen in the resulting crack mitigating layer 130a comprising an organosilicate result in a layer with a relatively lower elastic modulus (i.e., a 'softer' coating). Conversely, higher percentages of silicon and oxygen in the crack mitigating layer 130a comprising an organosilicate result in a layer with a relatively higher elastic modulus (i.e., a 'harder' coating). Advantageously, the TMS gas to $O_2$ gas ratio can be controlled during the vapor deposition process to develop a crack mitigating layer 130a with higher percentages of carbon and hydrogen or silicon and oxygen to tailor the elastic modulus of the layer 130a. For example, increasing the TMS/$O_2$ ratio tends to increase the amount of carbon and hydrogen in the layer 130a, thus decreasing its elastic modulus. On the other hand, decreasing the TMS/$O_2$ ratio tends to increase the amount of silicon and oxygen in the layer 130a, thus increasing its elastic modulus. With these levels, a crack mitigating layer 130a comprising an organosilicate material can be tailored with mechanical properties to obtain a desirable level of scratch resistance of the scratch-resistant film 110 of the laminate article 100a (e.g., by reducing the likelihood of cohesive failures in the crack mitigating layer 130a) while also ensuring that the strength of the underlying glass-based substrate 120 is maintained (e.g., by virtue of facilitating crack deflection) despite the addition of the scratch-resistant film 110.

In certain aspects of the disclosure (outside the scope of the claims), the crack mitigating layer 130a (see FIG. 1A) is characterized by an elastic modulus of 30 GPa or less, 25 GPa or less, 24 GPa or less, 23 GPa or less, 22 GPa or less, 21 GPa or less, 20 GPa or less, 19 GPa or less, 18 GPa or less, 17 GPa or less, 16 GPa or less, 15 GPa or less, 14 GPa or less, 13 GPa or less, 12 GPa or less, 11 GPa or less, 10 GPa or less, 9 GPa or less, 8 GPa or less, 7 GPa or less, 6 GPa or less, 5 GPa or less, 4 GPa or less, 3 GPa or less, 2 GPa or less, or 1 GPa or less, and all ranges and sub-ranges between the foregoing values. In some aspects, the crack mitigating layer 130a is characterized by an elastic modulus from about 25 GPa to about 0.1 GPa. In some embodiments, the crack mitigating layer 130a is characterized by an elastic modulus in the range of about 10 GPa to about 25 GPa.

According to some embodiments, a crack mitigating stack 130b (see FIG. 1B) comprising one or more bi-layers 23 (e.g., *N* bi-layers 23 can range from 1 to 100 in some embodiments) can be fabricated for use in laminate article 100b, with each layer (e.g., layers 33, 35) of the bi-layer 23 comprising an organosilicate material. More particularly, each layer of the bi-layers 23 can be fabricated using the foregoing techniques and structures associated with the crack mitigating layer 130a. Consequently, the crack mitigating stack 130b can influence the laminate articles 100b such that they can be characterized by the same, or even better, mechanical properties in comparison to the laminate articles 100a.

In certain aspects, the layers (e.g., layers 33, 35) making up each bi-layer 23 of the crack mitigating stack 130b can be fabricated with different mechanical properties (e.g., elastic modulus) by merely adjusting the TMS and $O_2$ gas

flow rates and/or the TMS/$O_2$ gas ratios during deposition over prescribed time periods defined based on desired thicknesses for the layers making up each bi-layer 23. In some embodiments of the crack mitigating stack 130b, the first layer 33 of the bi-layer 23 disposed on the glass-based substrate 120 is fabricated with an elastic modulus that is lower than the elastic modulus of the second layer 35 of the bi-layer 23. In addition, N bi-layers 23 can be employed in the crack mitigating stack 130b with N being set from 2 to 10 bi-layers 23 and, preferably, N is set to a value of 3. In other implementations, the stack 130b can be fabricated from one or more multi-layers (not shown, instead of bi-layers) in which each multi-layer comprises three or more individual layers, some or all of which have differing mechanical properties.

In certain implementations, the bi-layers 23 of the crack mitigating stack 130b (see FIG. 1B) can be characterized with an effective elastic modulus of 30 GPa or less, 25 GPa or less, 24 GPa or less, 23 GPa or less, 22 GPa or less, 21 GPa or less, 20 GPa or less, 19 GPa or less, 18 GPa or less, 17 GPa or less, 16 GPa or less, 15 GPa or less, 14 GPa or less, 13 GPa or less, 12 GPa or less, 11 GPa or less, 10 GPa or less, 9 GPa or less, 8 GPa or less, 7 GPa or less, 6 GPa or less, 5 GPa or less, 4 GPa or less, 3 GPa or less, 2 GPa or less, or 1 GPa or less, and all ranges and sub-ranges between the foregoing values. In some aspects, the crack mitigating stack 130b is characterized by an effective elastic modulus from about 25 GPa to about 0.1 GPa. In some embodiments, the crack mitigating stack 130b is characterized by an elastic modulus in the range of about 10 GPa to about 25 GPa. In other implementations, the first layer 33 of a bi-layer 23 is characterized by elastic modulus values that range from 1 GPa to about 20 GPa; and the second layer 35 of the bi-layer 23 is characterized by elastic modulus values that range from about 10 GPa to about 40 GPa.

Further, the crack mitigating stack 130b of one or more embodiments of the laminate articles 100a, 100b (see FIGS. 1A and 1B) may exhibit higher temperature tolerance, robustness to UV ozone or plasma treatments, UV transparency, robustness to environmental aging, low outgassing in vacuum, and the like.

According to some aspects of the disclosure (outside the scope of the claims), the scratch-resistant film 110 of the laminate article 100a, which comprises a crack mitigating layer 130a, is characterized by no peeling or substantially no peeling from the article upon exposure of the film 110 to a Garnet scratch test. According to some embodiments, the scratch-resistant film 110 of the laminate article 100b, which comprises a crack mitigating stack 130b, is characterized by no peeling or substantially no peeling from the article upon exposure of the film 110 to a Garnet scratch test.

As used herein, the "Garnet scratch test" is performed by attaching a ~6 mm diameter circular piece of 150 grit garnet sandpaper to the head of a Taber Abraser unit using a double-sided adhesive tape. A total of 1 kg load is applied to the abrasive head (~650 g added load plus ~350 g spindle load). Alternately, a total of 4 kg load may be applied. The abrasive head is then swept in a single scratching pass of ~30 mm length over the surface of the sample, which is then inspected for scratches. Although some scratches or damage marks may be visible on the sample, the criteria of "substantially no peeling," as used herein, is defined as having no visible regions in the center of the -30 mm Garnet scratch path larger than about 100 microns in any spatial dimension where the scratch resistant film 110 is completely removed from the substrate, when inspected using an optical microscope. Put another way, "peeling" or a "peeling-related failure," is defined as complete removal of the scratch resistant film(s) after undergoing the Garnet scratch test. Aspects of the disclosure exhibit substantially no peeling according to this criterion when subjected to Garnet scratch testing with both 1 kg and 4 kg total applied load.

The crack mitigating stack 130b (see FIGS. 1B) may be substantially optically transparent and free of light scattering, for example having an optical transmission haze of 10 % or less, 9% or less, 8% or less, 7% or less, 6% or less, 5% or less, 4% or less, 3% or less, 2% or less, 1% or less and all ranges and sub-ranges therebetween. The transmission haze of the layer may be controlled by controlling the average sizes of pores within the crack mitigating layer 130a or stack 130b, as defined herein. Exemplary average pore sizes in the layer may include 200 nm or less, 100 nm or less, 90 nm or less, 80 nm or less, 70 nm or less, 60 nm or less, 50 nm or less, 40 nm or less, 30 nm or less, 20 nm or less, 10 nm or less, 5 nm or less and all ranges and sub-ranges therebetween. These pore sizes can be estimated from light scattering measurements, or directly analyzed using transmission electron microscopy (TEM) and other known methods.

Porosity and mechanical properties of the crack mitigating stack 130b can be controlled using careful control of deposition methods for example a slight overpressure of gas in the vacuum chamber, low temperature deposition, deposition rate control, and plasma and/or ion-beam energy modification. Although vapor deposition methods are commonly used, other known methods can be used to provide a crack mitigating stack 130b with the desired porosity and/or mechanical properties.

For certain applications, porosity can be intentionally introduced into the crack mitigating stack 130b by use of a pore former (for example a block copolymer pore former) which is later dissolved or thermally decomposed, phase separation methods, or the casting of a particulate or nanoparticulate layer where interstices between particles remain partially void. In certain aspects of the disclosure, the crack mitigating stack 130b can be prepared with nano-porosity by combined vapor deposition and decomposition methods. These methods include the deposition of a matrix and inert poromers or porogens. The poromers or porogens are then removed from the stack 130b in a subsequent decomposition step to effect the desired nano-porosity. Accordingly, the inert porogens or poromers are appropriately sized, sieved or otherwise processed with regard to their final dimensions and density within the matrix in view of desired nanoporosity in the final, as-processed stack 130b.

In some embodiments, the crack mitigating stack 130b may exhibit a similar refractive index to either the glass-based substrate 120 and/or scratch-resistant film 110 to minimize optical interference effects. Accordingly, the crack mitigating stack 130b can exhibit a refractive index that is somewhat above, equal to or somewhat below the refractive indices of the substrate 120 and/or the scratch-resistant film 110. Additionally or alternatively, the crack mitigating stack 130b may exhibit a refractive index that is tuned to achieve anti-reflective interference effects. The refractive index of the crack mitigating stack 130b can be engineered somewhat by controlling the porosity and/or nano-porosity of the layer. For example, in some cases it may be desirable to choose a material with a relatively high refractive index, which when made into a crack mitigating stack 130b with a targeted porosity level can exhibit an intermediate refractive index in the range from about 1.4 to about 1.8 or a refractive index that approximates or is slightly higher than the refractive index of the glass-based substrate (e.g., in the range from about 1.45 to about 1.6). The refractive index of the crack mitigating stack 130b can be related to the porosity level using "effective index" models that are known in the art.

The thickness 13b of the crack mitigating stack 130b employed in laminate article 100b may be in the range of about 0.001 $\mu$m to about 10 $\mu$m (1 nm to 10,000 nm) or in the range from about 0.005 $\mu$m to about 0.5 $\mu$m (5 nm to about 500 nm), from about 0.01 $\mu$m to about 0.5 $\mu$m (10 nm to about 500 nm), from about 0.02 $\mu$m to about 0.2 $\mu$m (20 nm to about 200 nm). In one or more embodiments, thickness 13b of the stack 130b is in the range from about 0.02 $\mu$m to about 10 $\mu$m, from about 0.03 $\mu$m to about 10 $\mu$m, from about 0.04 $\mu$m to about 10 $\mu$m, from about 0.05 $\mu$m to about 10 $\mu$m, from about 0.06 $\mu$m to about 10 $\mu$m, from about 0.07 $\mu$m to about 10 $\mu$m, from about 0.08 $\mu$m to about 10 $\mu$m, from about 0.09 $\mu$m to about 10 $\mu$m, from about 0.1 $\mu$m to about 10 $\mu$m, from about 0.01 $\mu$m to about 9 $\mu$m, from about 0.01 $\mu$m to about 8 $\mu$m, from about 0.01 $\mu$m to about 7 $\mu$m, from about 0.01 $\mu$m to about 6 $\mu$m, from about 0.01 $\mu$m to about 5 $\mu$m, from about 0.01 $\mu$m to about 4 $\mu$m, from about 0.01 $\mu$m to about 3 $\mu$m, from about 0.01 $\mu$m to about 2 $\mu$m, from about 0.01 $\mu$m to about 1 micron, from about 0.02 $\mu$m to about 1 micron, from about 0.03 to about 1 $\mu$m, from about 0.04 $\mu$m to about 0.5 $\mu$m, from about 0.05 $\mu$m to about 0.25 $\mu$m or from about 0.05 $\mu$m to about 0.15 $\mu$m, and all ranges and sub-ranges between the foregoing values. In one or more specific embodiments, the thickness 13b of the stack 130b may be about 30 nm or less, about 20 nm or less, about 10 nm or less, about 5 nm or less, about 4 nm or less, about 3 nm or less, about 2 nm or less or about 1 nm or less.

In some embodiments of the disclosure, the thickness 13b of the crack mitigating stack 130b employed in the laminate article 100b (see FIG. 1B) ranges from about 100 nm to about 500 nm, preferably from about 150 nm to about 450 nm. According to some embodiments of the laminate article 100b, the first layer 33 of a bi-layer 23 has a thickness that ranges from about 10 nm to about 80 nm, preferably about 20 nm to about 70 nm, and all ranges and sub-ranges between the foregoing values; and the second layer 35 of a bi-layer 23 has a thickness that ranges from about 3 nm to about 50 nm, preferably about 5 nm to about 40 nm, and all ranges and sub-ranges between the foregoing values.

In one or more embodiments, thicknesses of the glass-based substrate 120, scratch-resistant film 110 and/or crack mitigating stack 130b may be specified in relation to one another (see FIGS. 1B). For example, the crack mitigating stack 130b may have a thickness 13b that is less than or equal to about 10 times the thickness 11 of the scratch-resistant film 110. In another example, where a scratch-resistant film 110 has a thickness 11 of about 85 nm, the crack mitigating stack 130b may have a thickness 13a, 13b of about 850 nm or less. In yet another example, the thickness 13b of the crack mitigating stack 130b may be in the range from about 35 nm to about 80 nm and the film 110 may have a thickness 11 in the range from about 30 nm to about 300 nm. In a further example, the thickness 13b of the crack mitigating stack 130b may be in the range from about 150 nm to about 450 nm and the thickness 11 of the scratch-resistant film 110 is in the range from about 1 micron to about 3 microns.

In one variant, the crack mitigating stack 130b may have a thickness 13b that is less than or equal to about 9 times, 8 times, 7 times, 6 times, 5 times, 4 times, 3 times or two times the thickness 11 of the film 110, and all ranges and sub-ranges between the foregoing values. In another variant, the thickness 11 of the film 110 and the thickness 13b of the crack mitigating stack 130b are each less than about 10 $\mu$m, less than about 5 $\mu$m, less than about 2 $\mu$m, less than about 1 $\mu$m, less than about 0.5 $\mu$m, or less than about 0.2 $\mu$m, and all ranges and sub-ranges between the foregoing values. The ratio of the crack mitigating stack 130b thickness 13b to the film 110 thickness 11 may be, in some embodiments, in the range from about 1:1 to about 1:20, in the range from about 1:2 to about 1:6, in the range from about 1:3 to about 1:5, or in the range from about 1:3 to about 1:4, and all ranges and sub-ranges between the foregoing values. In another variant, the thickness 13b of the crack mitigating stack 130b is less than about 0.4 $\mu$m and the thickness 11 of the film 110 is greater than the crack mitigating stack 130b.

One or more embodiments of the laminate articles 100a, 100b include a crack mitigating stack 130b comprising an organosilicate material. In such embodiments, when the crack mitigating stack 130b is utilized, the scratch-resistant film 110 maintains functional properties (e.g., optical properties, electrical properties and mechanical properties) and the article 100a, 100b retains its average flexural strength. In such embodiments, the film 110 may include one or more transparent conductive oxide layers, for example indium-tin-oxide layers or scratch-resistant layer, for example AlOxNy, AlN and combinations thereof. In addition, the glass-based substrate 120 may be strengthened, or more specifically, chemically strengthened.

Additionally or alternatively, the scratch-resistant film 110 including one or more of an indium-tin-oxide layer, a scratch-resistant layer (e.g., AlOxNy, AlN and combinations thereof), and an anti-reflective layer; and the crack mitigating stack 130b comprising an organosilicate material form a stack element, wherein the stack element has an overall low optical reflectance. For example, the overall (or total) reflectance of such a stack element may be 15% or less, 10% or less, 8% or less, 7% or less, 6.5% or less, 6% or less, 5.5% or less, and all ranges and sub-ranges between the foregoing values, across a visible wavelength range from 450-650 nm, 420-680 nm, or even 400-700 nm. The reflectance numbers above may be present in some embodiments including the reflectance from one bare (or uncoated) glass interface (e.g., of the glass-based substrate 120), which is approximately 4% reflectance from the uncoated glass interface alone, or may be characterized as the reflectance for a first major surface of a glass-based substrate 120 and the stack element (and associated interfaces) disposed on the first major surface (excluding the 4% reflectance from an uncoated second major surface of the glass-based substrate). The reflectance from the stack element structure and the stack element-glass coated interfaces alone (subtracting out the reflectance of the uncoated glass interface) may be less than about 5%, 4%, 3%, 2%, or even less than about 1.5%, and all ranges and sub-ranges between the foregoing values, across a visible wavelength range from 450-650 nm, 420-680 nm, or even 400-700 nm, in some cases when one or more major surfaces of the glass-based substrate 120 is covered by a typical encapsulant (i.e., an additional film or layer) having an encapsulant refractive index of about 1.45-1.65. In addition, the stack element may exhibit a high optical transmittance, which indicates both low reflectance and low absorptance, according to the general relationship: Transmittance = 100% - Reflectance - Absorptance. The transmittance values for the stack element (when neglecting reflectance and absorptance associated with the glass-based substrate 120 or encapsulant layers alone) may be greater than about 75%, 80%, 85%, 90%, 95%, or even 98%, and all ranges and sub-ranges between the foregoing values, across a visible wavelength range from 450-650 nm, 420-680 nm, or even 400-700 nm.

The optical properties of the laminate articles 100a, 100b (see FIGS. 1A and 1B) may be adjusted by varying one or more of the properties of the scratch-resistant film 110, crack mitigating stack 130b and/or the glass-based substrate 120. For example, the articles 100a, 100b may exhibit a total reflectance of 15% or less, 10% or less, 8% or less, 7% or less, 6.9% or less, 6.8% or less, 6.7% or less, 6.6% or less, 6.5% or less, 6.4% or less, 6.3% or less, 6.2% or less, 6.1% or less and/or 6% or less, and all ranges and sub-ranges between the foregoing values, over the visible wavelength range from about 400 nm to about 700 nm. Ranges may further vary as specified hereinabove, and ranges for the stack element (i.e., as including the scratch-resistant film 110 and the crack mitigating stack 130b) / coated glass interfaces alone are listed hereinabove. In more specific embodiments, the articles 100a, 100b described herein may exhibit a lower average reflectance and greater average flexural strength than articles without a crack mitigating stack 130b. In one or more alternative embodiments, at least two of optical properties, electrical properties or mechanical properties of the article 100a, 100b may be adjusted by varying the thickness(es) of the glass-based substrate 120, film 110 and/or the crack mitigating stack 130b. Additionally or alternatively, the average flexural strength of the articles 100a, 100b may be adjusted or improved by modifying the thickness(es) of the glass-based substrate 120, film 110 and/or the crack mitigating stack 130b.

Additionally, glass-based substrates coated with the crack mitigating layer may have a reflectance that is within 2% or within 1% of the glass-based substrate alone. The crack mitigating layer may have a refractive index which is less than 1.55, from 1.35 to 1.55, or no greater than 0.05 higher than the refractive index of the substrate. The crack mitigating layer may also have a combined absorptance and scattering level that is less than 5% of the incident optical energy across a visible wavelength range from 400-800 nm.

The articles 100a, 100b (see FIGS. 1A and 1B) may include one or more additional films (not shown) disposed on the glass-based substrate 120. In one or more embodiments of the article 100a, 100b, the one or more additional films may be disposed on the scratch-resistant film 110 or, as is more typical, on the opposite major surface from the film 110. Certain of the additional film(s) may be disposed in direct contact with the film 110. In one or more embodiments, the additional film(s) may be positioned between: 1) the glass-based substrate 120 and the crack mitigating stack 130b (e.g., in laminate articles 100a, 100b); or 2) the crack mitigating stack 130b and the film 110. In one or more embodiments, both the crack mitigating stack 130b and the film 110 may be positioned between the glass-based substrate 120 and the additional film(s). The additional film(s) may include a protective layer, an adhesive layer, a planarizing layer, an anti-splintering layer, an optical bonding layer, a display layer, a polarizing layer, a light-absorbing layer, reflection-modifying interference layers, scratch-resistant layers, barrier layers, passivation layers, hermetic layers, diffusion-blocking layers and combinations thereof, and other layers known in the art to perform these or related functions. Examples of suitable protective or barrier layers include layers containing $SiO_x$, $SiN_y$, $SiO_xN_y$, other similar materials and combinations thereof. Such layers can also be modified to match or complement the optical properties of the scratch-resistant film 110, the crack mitigating stack 130b and/or the glass-based substrate 120. For example, the protective layer may be selected to have a similar refractive index as the crack mitigating stack 130b, the film 110, or the glass-based substrate 120.

In one or more embodiments, the article 100b described may be used in information display devices and/or touch-sensing devices. In one or more alternative embodiments, the article 100b may be part of a laminate structure, for example, as a glass-polymer-glass laminated safety glass to be used in automotive or aircraft windows. An exemplary polymer material used as an interlayer in these laminates is PVB (polyvinyl butyral), and there are many other interlayer materials known in the art that can be used. In addition, there are various options for the structure of the laminated glass, which are not particularly limited. The article 100b may be curved or shaped in the final application, for example as in an automotive windshield, sunroof, or side window. The thickness 10a, 10b, of the article 100b can vary, for either design or mechanical reasons; for example, the article 100b can be thicker at the edges than at the center of the article. The article 100b may be acid-polished or otherwise treated to remove or reduce the effect of surface flaws.

Some embodiments of the present disclosure pertains to cover glass applications that utilize the article 100b described herein. In one or more embodiments, the cover glass may include a laminated article with a glass-based substrate 120 (which may be strengthened or not strengthened), a scratch-resistant film 110 (e.g., $AlO_xN_y$, AlN, $SiO_xN_y$, $SiAl_vO_xN_y$, $Si_3N_4$ and combinations thereof), and the crack mitigating stack 130b comprising one or more organosilicate materials. The laminated article 100b may include one or more additional film(s) for reducing the reflection and/or providing an easy-to-clean or anti-fingerprint surface on the laminated article. In particular, a ~ 1-10 nm thick silane or fluorosilane layer may be applied to the surface of the scratch-resistant layer to reduce friction, improve cleanability, or aid in scratch reduction at the user surface of the article.

Some embodiments of the present disclosure pertains to touch-sensing devices including the articles described herein. In one or more embodiments, the touch sensor device may include a glass-based substrate 120 (which may be strengthened or not strengthened), a scratch-resistant film 110 (e.g., as comprising a transparent conductive oxide and a scratch-resistant material, e.g., $AlO_xN_y$, AlN, $SiO_xN_y$, $SiAl_vO_xN_y$, $Si_3N_4$ and combinations thereof) and a crack mitigating stack 130b. The transparent conductive oxide may include indium-tin-oxide, aluminum-zinc-oxide, fluorinated tin oxide, or others known in the art. In one or more embodiments, the conductive oxide portion of the scratch-resistant film 110 is discontinuously disposed on the glass-based substrate 120. In other words, conductive portions of the scratch-resistant film 110 may be disposed on discrete regions of the glass-based substrate 120 (with crack mitigating stack 130b, therebetween). The discrete regions with the film form patterned or coated regions (not shown), while the discrete regions without the film form unpatterned or uncoated regions (not shown). In one or more embodiments, the patterned or coated regions and unpatterned or uncoated regions are formed by disposing the film 110 continuously on a surface of the crack mitigating layer 130a, or stack 130b, which in turn is on the surface of the glass-based substrate 120 and then selectively etching away the film 110 in the discrete regions so that there is no film 110 in those discrete regions. The film 110 may be etched away using an etchant for example HCl or $FeCl_3$ in aqueous solutions, for example the commercially available TE-100 etchant from Transene Co. In one or more embodiments, the crack mitigating stack 130b is not significantly degraded or removed by the etchant. Alternatively, the film 110 may be selectively deposited onto discrete regions of a surface the crack mitigating stack 130b, which in turn is on the surface of the glass-based substrate 120 to form the patterned or coated regions and unpatterned or uncoated regions.

In one or more embodiments of the laminate article 100b having a scratch-resistant film 110 that includes conductive oxide portions or discrete regions, the uncoated regions have a total reflectance that is similar to the total reflectance of the coated regions. In one or more specific embodiments, the unpatterned or uncoated regions have a total reflectance that differs from the total reflectance of the patterned or coated regions by about 5% or less, 4.5% or less, 4% or less, 3.5% or less, 3% or less, 2.5% or less, 2.0% or less, 1.5% or less or even 1% or less, and all ranges and sub-ranges between the foregoing values, across a visible wavelength in the range from about 450 nm to about 650 nm, from about 420 nm to about 680 nm or even from about 400 nm to about 700 nm.

In some embodiments of the present disclosure, article 100b including both a crack mitigating a stack 130b and a scratch-resistant film 110, which may include indium-tin-oxide or other transparent conductive oxides, exhibit resistivity that is acceptable for use of such articles in touch sensing devices. In one or more embodiments, the films 110, when present in the articles disclosed herein, exhibit a sheet resistance of about 100 ohm/square or less, 80 ohm/square or less, 50 ohm/square or less, or even 30 ohm/square or less. In such embodiments, the film may have a thickness of about 200 nm or less, 150 nm or less, 100 nm or less, 80 nm or less, 50 nm or less or even 35 nm or less, and all ranges and sub-ranges between the foregoing values. In one or more specific embodiments, such films, when present in the article 100, exhibit a resistivity of $10 \times 10^{-4}$ ohm-cm or less, $8 \times 10^{-4}$ ohm-cm or less, $5 \times 10^{-4}$ ohm-cm or less, or even $3 \times 10^{-4}$ ohm-cm or less, and all ranges and sub-ranges between the foregoing values. Thus, the scratch-resistant films 110, when present in the article 100b disclosed herein with conductive oxide portions, can favorably maintain the electrical and optical performance expected of transparent conductive oxide films and other such films used in touch sensor applications, including projected capacitive touch sensor devices.

The disclosure herein can also be applied to articles 100b which are not interactive or for display; for example, such articles may be used in a case in which a device has a glass front side that is used for display and can be interactive, and a back side that might be termed "decorative" in a very broad sense, meaning that backside can be "painted" in some color, have art work or information about the manufacturer, model and serial number, texturing or other features.

With regard to the optical properties of the laminate article 100b (see FIGS. 1A and 1B), the scratch-resistant film 110 can comprise a scratch-resistant material, for example AlN, $Si_3N_4$, $AlO_xN_y$, and $SiO_xN_y$, which possesses a relatively high refractive index in the range from about 1.7 to about 2.1. The glass-based substrates 120 employed in laminate articles 100a and 100b typically have refractive indices in the range from about 1.45 to about 1.65. Further, the crack mitigating stack 130b employed in articles 100a and 100b typically has a refractive index somewhere near or between the refractive index ranges common to the substrate 120 and the film 110 (when present). The differences in these refractive index values (e.g., between the substrate 120 and the crack mitigating stack 130b) can contribute to undesirable optical interference effects. In particular, optical interference at the interfaces 150 and/or 160 (see FIGS. 1A and 1B) can lead to spectral reflectance oscillations that create apparent color observed in the articles 100a and 100b. The color shifts in reflection with viewing angle due to a shift in the spectral reference oscillations with incident illumination angle. Ultimately, the observed color and color shifts with incident illumination angle are often distracting or objectionable to device users, particularly under illumination with sharp spectral features for example fluorescent lighting and some LED lighting.

According to aspects of this disclosure, observed color and color shifts in the article 100b can be reduced by minimizing reflectance at one or both of the interfaces 150 and 160 (see FIGS. 1A and 1B), thus reducing reflectance oscillations and reflected color shifts for the entire article. In some aspects, the density, thickness, composition and/or porosity of the crack mitigating stack 130b can be tailored to minimize such reflectance at the interfaces 150 and 160. For example, configuring the stack 130b according to the foregoing aspects can reduce the amplitudes and/or oscillations of the reflectance across the visible spectrum.

As used herein, the term "amplitude" includes the peak-to-valley change in reflectance or transmittance. As also used herein, the term "transmittance" is defined as the percentage of incident optical power within a given wavelength range transmitted through the article 100b. The term "average transmittance" refers to the spectral average of the light transmission multiplied by the luminous efficiency function, as described by CIE standard observer. The term "reflectance" is similarly defined as the percentage of incident optical power within a given wavelength range that is reflected from the article 100b. In general, transmittance and reflectance are measured using a specific line width. Furthermore, the phrase "average amplitude" includes the peak-to-valley change in reflectance or transmittance averaged over every possible 100 nm wavelength range within the optical wavelength regime. As used herein, the "optical wavelength regime" includes the range from about 420 nm to about 700 nm.

According to one or more embodiments, the laminated article 100b exhibits an average transmittance of 85% or greater over the visible spectrum. In some embodiments, the laminated article 100b can exhibit an average transmittance of 80% or greater, 82% or greater, 85% or greater, 90% or greater, 91% or greater, 92% or greater, 93% or greater, 94% or greater, or 95% or greater, and all ranges and sub-ranges between the foregoing values.

In some aspects, the articles 100a and 100b exhibit an average total reflectance of 20% or less over the visible spectrum. Certain embodiments of the article 100b, for example, exhibit a total reflectance of 20% or less, 15% or less, 10% or less, 9% or less, 8% or less, 7% or less, 6% or less, or 5% or less, and all ranges and sub-ranges between the foregoing values.

In accordance with one or more embodiments, the article 100b has a total reflectivity that is the same or less than the total reflectivity of the glass-based substrate 120. In one or more embodiments, the article 100b exhibits a relatively flat transmittance spectrum, reflectance spectrum or transmittance and reflectance spectrum over the optical wavelength regime. In some embodiments, the relatively flat transmittance and/or reflectance spectrum includes an average oscillation amplitude of about 5 percentage points or less along the entire optical wavelength regime or wavelength range segments in the optical wavelength regime. Wavelength range segments may be about 50 nm, about 100 nm, about 200 nm or about 300 nm, and all ranges and sub-ranges between the foregoing values. In some embodiments, the average oscillation amplitude may be about 4.5 percentage points or less, about 4 percentage points or less, about 3.5 percentage points or less, about 3 percentage points or less, about 2.5 percentage points or less, about 2 percentage points or less, about 1.75 percentage points or less, about 1.5 percentage points or less, about 1.25 percentage points or less, about 1 percentage point or less, about 0.75 percentage points or less, about 0.5 percentage points of less, about 0.25 percentage points or less, or about 0 percentage points, and all ranges and sub-ranges therebetween. In one or more specific embodiments, the articles 100 and 100a exhibit a transmittance over a selected wavelength range segment of about 100 nm or 200 nm over the optical wavelength regime, wherein the oscillations from the spectra have a maximum peak of about 80%, about 82%, about 84%, about 86%, about 87%, about 88%, about 89%, about 90%, about 91%, about 92%, about 93%, about 94%, or about 95%, and all ranges and sub-ranges therebetween.

In some embodiments, the relatively flat average transmittance and/or average reflectance includes maximum oscillation amplitude, expressed as a percent of the average transmittance or average reflectance, along a specified wavelength range segment in the optical wavelength regime. The average transmittance or average reflectance of the laminated article 100b would also be measured along the same specified wavelength range segment in the optical wavelength regime. The wavelength range segment may be about 50 nm, about 100 nm or about 200 nm. In one or more embodiments, the articles 100 and 100a exhibit an average transmittance and/or average reflectance with an average oscillation amplitude of about 10% or less, about 5% or less, about 4.5% or less, about 4 % or less, about 3.5% or less, about 3% or less, about 2.5% or less, about 2% or less, about 1.75% or less, about 1.5% or less, about 1.25% or less, about 1% or less, about 0.75% or less, about 0.5% or less, about 0.25% or less, or about 0.1% or less, and all ranges and sub-ranges therebetween. Such percent-based average oscillation amplitude may be exhibited by the article along wavelength ranges segments of about 50 nm, about 100 nm, about 200 nm or about 300 nm, in the optical wavelength regime. For example, an article according to this disclosure may exhibit an average transmittance of about 85% along the wavelength range from about 500 nm to about 600 nm, which is a wavelength range segment of about 100 nm, within the optical wavelength regime. The article may also exhibit a percent-based oscillation amplitude of about 3% along the same wavelength range (500 nm to about 600 nm), which means that along the wavelength range from 500 nm to 600 nm, the absolute (non-percent-based) oscillation amplitude is about 2.55 percentage points. For example, if the average transmittance is 85%, and the oscillations represent 3% of the 85%, then in absolute terms 3% multiplied by 85% equals 2.55%, meaning that the oscillation amplitude peak will be 86.275 and valley will be 83.725 in absolute terms, since 85% is the average and 86.275-83.725 = 2.55.

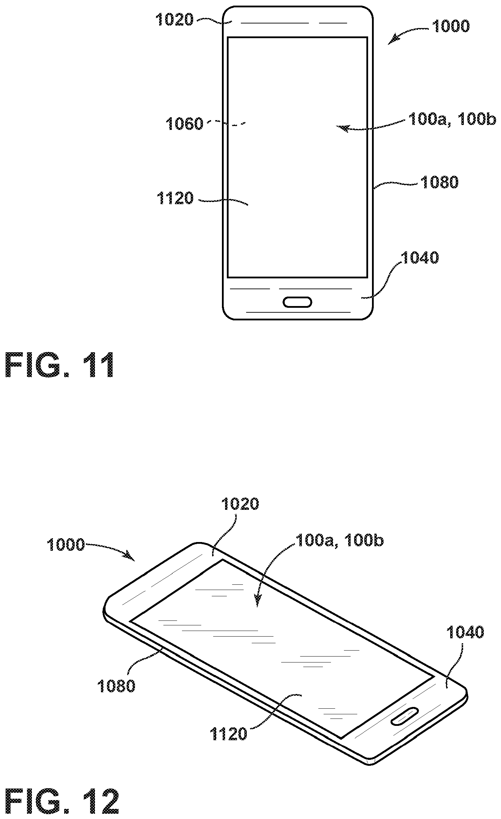

Some embodiments pertain to a device incorporating the article 100b disclosed herein, as shown in FIGS. 11 and 12. The device shown in FIGS. 11-12 is a mobile phone but can include any device or article with a display (e.g., consumer electronics, including mobile phones, tablets, computers, wearables (e.g. watches), navigation systems, and the like), architectural articles, transportation articles (e.g., automotive, trains, aircraft, sea craft, etc.), appliance articles, or any article in which some transparency, scratch-resistance, abrasion resistance or a combination thereof is desired. FIG. 1a shows a consumer electronic device 1000 including a housing 1020 having front 1040, back 1060, and side surfaces 1080; electrical components (not shown) that are at least partially inside or entirely within the housing and including at least a controller, a memory, and a display 1120 at or adjacent to the front surface of the housing; and an article 100b at or over the front surface of the housing such that it is over the display. In some embodiments, the housing 1020 may include article 100b at any one or more of the back 1060, side surfaces 1080, or portions of the front 1040.

Some embodiments of the present disclosure pertain to methods of forming article 100b. In one or more embodiments, such methods include obtaining a glass-based substrate 120, disposing a scratch-resistant film 110 on a first major surface of the glass-based substrate to create an effective interface therebetween and controlling the effective adhesion energy of the effective interface. In certain aspects, such methods include obtaining a glass-based substrate 120 and creating an effective interface on the substrate, and controlling the effective adhesion energy of the effective interface. In one or more embodiments, the method includes controlling the effective adhesion energy to less than about 4 J/m$^2$. In one or more embodiments, controlling the effective adhesion energy includes disposing a crack mitigating stack 130b on a surface (e.g., one or more of the major surfaces 122, 124 and/or one or more minor surfaces) of the glass-based substrate 120, before disposing the scratch-resistant film 110 (e.g., for articles 100a, 100b). In other words, controlling the effective adhesion energy includes disposing a crack mitigating stack 130b between the film 110 and the glass-based substrate 120 for article 100b.

According to some implementations, the method of forming article 100b employs a crack mitigating stack 130b that includes an organosilicate material, e.g., methylated silica. As such, these methods for forming article 100b can employ steps for depositing the crack mitigating stack 130b that include any one of the following deposition techniques: atmospheric plasma chemical vapor deposition (AP-CVD), plasma-enhanced chemical vapor deposition (PECVD), or spin-on-glass (SOG) processing techniques. In some aspects, the organosilicate materials are characterized by a siloxane network with an average silicon connectivity of less than four where each silicon atom on average has some non-zero probability of being directly bonded with up to three organic groups. Typically, such materials are formed by a reaction of mono-, di- or tri-functional organosilicon compounds, optionally with other additions for example silicon precursors and oxidizers.

In one or more embodiments, the method includes disposing the scratch-resistant film 110 and/or the crack mitigating stack 130b via a vacuum deposition process. In particular embodiments, such vacuum deposition processes may utilize temperatures of at least about 25 °C, 50 °C, 75 °C, 100 °C, 200 °C, 300 °C, 400 °C and all ranges and sub-ranges therebetween. In some embodiments, the crack mitigating stack 130b may be formed by a wet process.

In one or more specific embodiments, the method includes controlling the thickness(es) of the crack mitigating stack 130b and/or the scratch-resistant film 110. Controlling the thickness(es) of the crack mitigating stack 130b and/or films (e.g., scratch-resistant film 110) disclosed herein may be performed by controlling one or more processes for forming the crack mitigating layer, stack and/or films so that the crack mitigating layer, stack and/or films are applied having a desired or defined thickness. In some embodiments, the method includes controlling the thickness(es) of the crack mitigating stack 130b and/or the scratch-resistant film 110 to maintain (or enhance, in some cases) the average flexural strength of the glass-based substrate 120, the functional properties of the glass-based substrate 120 and/or the functional properties of the film 110.

In one or more alternative embodiments, the method includes controlling the continuity of the crack mitigating stack 130b and/or the scratch-resistant film 110. Controlling the continuity of the crack mitigating stack 130b may include forming a continuous crack mitigating layer and removing a selected portion(s) of the crack mitigating layer or stack to create a discontinuous crack mitigating layer. In other embodiments, controlling the continuity of the crack mitigating layer or stack may include selectively forming the crack mitigating layer or stack to form a discontinuous crack mitigating layer or stack. Such embodiments may use a mask, an etchant and combinations thereof to control the continuity of the crack mitigating stack 130b.

In one or more alternative embodiments, the method includes controlling the surface energy of the crack mitigating stack 130b when it is disposed on the glass-based substrate 120 (with regard to methods of forming laminate article 100b), but before deposition of the scratch-resistant film 110 (with particular regard to article 100b). Controlling the surface energy of the crack mitigating stack 130b at this intermediate stage of fabrication may be useful for establishing a repeatable fabrication process. In one or more embodiments, the method includes controlling the surface energy of the crack mitigating stack 130b (as measured when the crack mitigating stack 130b is uncovered and exposed to air) to less than about 70 mJ/m$^2$ or less, 60 mJ/m$^2$ or less, 50 mJ/m$^2$ or less, 40 mJ/m$^2$ or less, 30 mJ/m$^2$ or less, 20 mJ/m$^2$ or less, but in some cases, greater than about 15 mJ/m$^2$, and all ranges and sub-ranges between the foregoing values. In one or more embodiments, the foregoing surface energy values and ranges include both polar and dispersion components and may be measured by fitting a known theoretical model developed by S. Wu (1971) to three contact angles of three test liquids: water, diiodomethane and hexadecane. (*See* S. Wu, J. Polym. Sci., Part C, vol. 34, pp. 19-30, 1971).

Surface Energy of the Crack Mitigation Layer

As referred to herein, the surface energy of the crack mitigation layer is a measure of the surface energy of the crack mitigation layer as it exists on the carrier. In general, the surface energy of the crack mitigation layer 30 can be measured upon being deposited and/or further treated, for example by activation with nitrogen or a mixture of nitrogen and oxygen. The surface energy of the solid surface is measured indirectly by measuring the static contact angles of three liquids- water, diiodomethane and hexadecane-individually deposited on the solid surface in air. Surface energies as disclosed herein were determined according to the Wu model, as set forth below. (See: S. Wu, J. Polym. Sci. C, 34, 19, 1971). In the Wu model, the surface energies, including total, polar, and dispersion components, are measured by fitting a theoretical model to three contact angles of three test liquids: water, diiodomethane and hexadecane. From the contact angle values of the three liquids, a regression analysis is done to calculate the polar and dispersion components of the solid surface energy. The theoretical model used to calculate the surface energy values includes the following three independent equations relating the three contact angle values of the three liquids and the dispersion and polar components of surface energies of the solid surface (denoted by the subscript "S") as well as the three test liquids:

$$\gamma_W \left(1 + \cos\theta_W\right) = 4 \left( \frac{\gamma_W^d \, \gamma_S^d}{\gamma_W^d + \gamma_S^d} + \frac{\gamma_W^p \, \gamma_S^p}{\gamma_W^p + \gamma_S^p} \right) \qquad (1)$$

$$\gamma_D \left(1 + \cos\theta_D\right) = 4 \left( \frac{\gamma_D^d \, \gamma_S^d}{\gamma_D^d + \gamma_S^d} + \frac{\gamma_D^p \, \gamma_S^p}{\gamma_D^p + \gamma_S^p} \right) \qquad (2)$$

$$\gamma_H \left(1 + \cos\theta_H\right) = 4 \left( \frac{\gamma_H^d \, \gamma_S^d}{\gamma_H^d + \gamma_S^d} + \frac{\gamma_H^p \, \gamma_S^p}{\gamma_H^p + \gamma_S^p} \right) \qquad (3)$$

where, the subscripts "W", "D" and "H" represent water, diiodomethane and hexadecane, respectively, and the superscripts "d" and "p" represent the dispersion and polar components of surface energies, respectively. Since diiodomethane and hexadecane are essentially non-polar liquids, the above set of equations reduces to:

$$\gamma_W \left(1 + \cos\theta_W\right) = 4 \left( \frac{\gamma_W^d \, \gamma_S^d}{\gamma_W^d + \gamma_S^d} + \frac{\gamma_W^p \, \gamma_S^p}{\gamma_W^p + \gamma_S^p} \right) \qquad (4)$$

$$\gamma_D \left(1 + \cos\theta_D\right) = 4 \left( \frac{\gamma_D^d \, \gamma_S^d}{\gamma_D^d + \gamma_S^d} \right) \qquad (5)$$

$$\gamma_H \left(1 + cos\ \theta_H\right) = 4 \left(\frac{\gamma_H^d\ \gamma_S^d}{\gamma_H^d + \gamma_S^d}\right) \qquad\qquad (6)$$

From the above set of three equations (4-6), the two unknown parameters, dispersion and polar surface energy components of the solid surface, $\gamma_S^d$ and $\gamma_S^p$ can be calculated by regression analysis. However, with this approach, there is a limiting maximum value up to which the surface energy of the solid surface could be measured. That limiting maximum value is the surface tension of water, which is about 73 mJ/m². If the surface energy of the solid surface is appreciably greater than the surface tension of water, the surface will be fully wetted by water, thereby causing the contact angle to approach zero. Beyond this value of surface energy, therefore, all calculated surface energy values would correspond to about 73-75 mJ/m² regardless of the real surface energy value. For example, if the real surface energies of two solid surfaces are 75 mJ/m² and 150 mJ/m², the calculated values using the liquid contact angles will be about 75 mJ/m² for both surfaces.

Accordingly, all contact angles disclosed herein are measured by placing liquid droplets on the solid surface in air and measuring the angle between the solid surface and the liquid-air interface at the contact line. Therefore, when a claim is made on the surface energy value being from 55 mJ/m² to 75 mJ/m² it should be understood that these values correspond to calculated surface energy values based on the method described above and not the real surface energy values, which could be greater than 75 mJ/m² when the calculated value approaches the real surface energy value.

In one or more embodiments, the method may include creating a controlled amount of porosity in the crack mitigating stack 130b. The method may optionally include controlling the porosity of the crack mitigating stack 130b as otherwise described herein. The method may further include controlling the intrinsic film stresses of the crack mitigating stack 130b and/or the film 110 through control of deposition and fabrication processes of the crack mitigating layer or stack.

The method may include disposing an additional film, as described herein, on the glass-based substrate 120. In one or more embodiments, the method may include disposing the additional film on the glass-based substrate such that the additional film is disposed between the glass-based substrate 120 and the crack mitigating stack 130b, between the crack mitigating stack 130b and the scratch-resistant film 110 or, such that the film 110 is between the crack mitigating stack 130b and the additional film. Alternatively, the method may include disposing the additional film on the opposite major surface of the glass-based substrate 120 from the surface on which the film is disposed.

In one or more embodiments, the method includes strengthening the glass-based substrate 120 before or after disposing the crack mitigating stack 130b, scratch-resistant film 110 and/or an additional film on the glass-based substrate. The glass-based substrate 120 may be strengthened chemically or otherwise. The glass-based substrate 120 may be strengthened after disposing the crack mitigating stack 130b on the glass-based substrate 120 but before disposing the film 110 on the glass-based substrate. The glass-based substrate 120 may be strengthened after disposing the crack mitigating stack 130b and the film 110 on the glass-based substrate 120 but before disposing an additional film (if any) on the glass-based substrate. Where no additional film is utilized, the glass-based substrate 120 may be strengthened after disposing the crack mitigating or stack 130b and the film 110 on the glass-based substrate. For glass-based substrates wherein low warp is desired, strengthening is performed before any coating; this will typically be the case.

The following examples represent certain non-limiting embodiments of the disclosure.

Example 1: Strength of laminated articles having organosilicate crack mitigating layers and stacks, as derived from TMS/$O_2$ gas mixtures in an inert working gas. In the below example only Example 2B falls within the scope of the claims and Example 2A is only provided for reference purposes.

Sample laminated articles designated Examples 1A-1C ("Exs. 1A-1C") and 2A, 2B ("Exs. 2A and 2B) were formed by providing glass-based substrates according to the following composition: $SiO_2$ of about 65 mol%, $B_2O_3$ of about 5 mol%, $Al_2O_3$ of about 14 mol%, $Na_2O$ of about 14 mol%, and MgO of about 2.5 mol%. The glass-based substrates had a thickness of 1 mm. The glass-based substrates were strengthened by ion exchange to provide a surface CS of about 690 MPa and a DOC of about 24 μm. The ion-exchange process was carried out by immersing the glass-based substrate in a molten potassium nitrate ($KNO_3$) bath that was heated to a temperature in the range from about 350 °C to 450 °C. The glass-based substrates were immersed in the bath for a duration of 3-8 hours to achieve the surface CS and DOC. After completing the ion exchange process, the glass-based substrates of Examples 1A-1C were cleaned in a 2% concentration KOH detergent solution, supplied by Semiclean KG, having a temperature of about 50 °C.

In Example 1, the Ex. 1A sample represents a control as it only contains a glass-based substrate. Similarly, the Ex. 1B sample also serves as a control because it contains a $SiN_x$ scratch-resistant film having a thickness of about 440 nm and lacks a crack mitigation layer or stack comprising an organosilicate material. In the Ex. 1B sample, the $SiN_x$ scratch-resistant film was deposited in a Plasma-Therm Versaline HDPCVD system at 200°C with a silane precursor gas and nitrogen gas. Further, the Ex. 1C sample also serves as a control because it contains a $SiN_x$ scratch-resistant film having a thickness of about 2 microns and lacks a crack mitigation layer or stack comprising an organosilicate material.

In Example 1, samples designated Ex. 2A and Ex. 2B were also prepared. For the Exs. 2A-2B samples, strengthened glass-based substrates and scratch-resistant films according to the Ex. 1B condition (e.g., a $SiN_x$ film having a thickness of about 440 nm) were prepared. In addition, Exs. 2A and 2B each possess a crack mitigation layer (Ex. 2A) or crack mitigating stack (Ex. 2B) comprising an organosilicate layer derived from trimethylsilicate (TMS) that was disposed between the substrates and the $SiN_x$ scratch-resistant films. Accordingly, the organosilicate layer(s) of the crack mitigating layer or stack were disposed over the glass-based substrates before the scratch-resistant films were deposited on the crack mitigating layer or stack. In Ex. 2A, the crack mitigating layer has a targeted thickness of about ~300 nm and an elastic modulus of about 7.6 GPa. In Ex. 2B, the crack mitigating stack comprises about three bi-layers, with each bi-layer having a targeted thickness of about 55 nm; the first layer of each bi-layer having a thickness of about 40 nm and an elastic modulus of about 7.6 GPa; and the second layer of each bi-layer having a thickness of about 15 nm and an elastic modulus of 29 GPa.

These crack mitigating layers and stacks in Exs. 2A and 2B were deposited using an atmospheric plasma chemical vapor deposition (APCVD) process in a linear DBD type atmospheric plasma system using 20-70 sccm TMS gas, about 130 sccm $O_2$ gas, and a plasma power of about 400-600W in air at about 70 to 100°C with a about a 2 to 5 mm distance between the plasma head and the glass-based substrate. Similarly, the TMS layers employed in Exs. 5C and 5D have a targeted thickness of 50 and ~300 nm, respectively. More particularly, the crack mitigating layer of the samples designated Ex. 2A were processed using 45 sccm TMS and 130 sccm $O_2$ gas. Further, the crack mitigating stack of the samples designated Ex. 2B were processed using 45 sccm TMS and 130 sccm $O_2$ gas for the first layer in each bi-layer and 25 sccm TMS and 130 sccm $O_2$ gas for the second layer in each bi-layer.

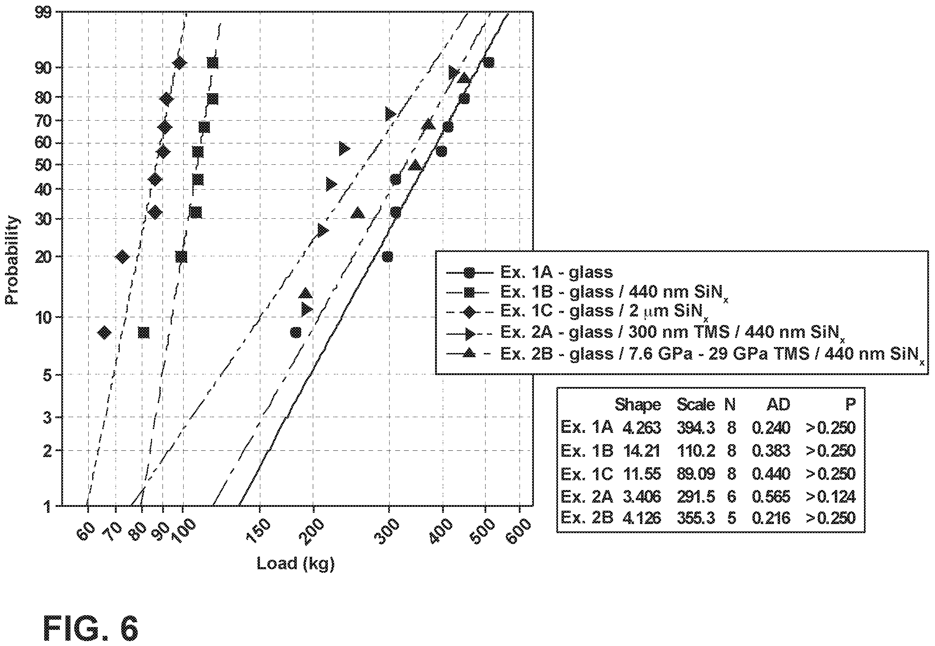

Ring-on-ring (ROR) load to failure testing was used to demonstrate the retention of average flexural strength of Exs. 1A-1C, 2A, and 2B, as shown in FIG. 6. For ROR load-to-failure testing, the side with the film and/or crack mitigating layer was placed in tension. The ROR load-to-failure testing parameters included a contact radius of 1.6 mm, a cross-head speed of 1.2 mm/minute, a load ring diameter of 1.27 cm (0.5 inches), and a support ring diameter of 2.54 cm (1 inch). Before testing, an adhesive film was placed on both sides of the sample being tested to contain broken glass shards.

As illustrated in FIG. 6, the addition of a crack mitigating layer or a crack mitigating stack (as comprising organosilicate material derived from TMS and $O_2$ gas) to a laminate article with a $SiN_x$ scratch-resistant film and glass-based substrate (Exs. 2A and 2B, respectively) resulted in laminate articles that retained about the same average flexural strength as similarly-configured laminate articles without such a crack mitigating layer or stack and scratch-resistant film (Ex. 1A). As also shown by FIG. 6, the inclusion of a scratch-resistant film with a thickness of 440 nm or 2 microns (see Exs. 1B, 1C) without any cracking mitigating layer or stack significantly reduces the average flexural strength of the glass-based substrate (see Ex. 1A). More particularly, the laminate article with the single organosilicate crack mitigating layer and a 440 nm $SiN_x$ scratch-resistant film (Ex. 2A) exhibited an average flexural strength of about 74% of the similarly-configured laminate article without such a crack mitigating layer or scratch-resistant film (Ex. 1A). Further, the laminate article with the organosilicate crack mitigating stack and a 440 nm $SiN_x$ scratch-resistant film (Ex. 2B) exhibited a Weibull characteristic strength of about 90% of the similarly-configured laminate article without such a crack mitigating stack and a scratch-resistant film (Ex. 1A). It is believed that the foregoing results obtained with the laminate articles employing the SiNx scratch-resistant films of this example can be extrapolated to other scratch-resistant film compositions, including $SiO_xN_y$, $AlN_x$, $AlO_xN_y$, and $Si_uAl_vO_xN_y$ materials. The basis for this expected trend includes the results from separate experiments that these alternative scratch-resistant materials can be made to have similar refractive index, hardness, elastic modulus, film stress, and crack onset strain values as the SiNx materials employed in this example. Accordingly, these alternative scratch-resistant film materials, with little modification in view of the principles outlined in this disclosure, can be made to act similarly in combination with organosilicate crack mitigating layers as described in the present examples.

While the laminate articles containing the crack mitigating stack (Ex. 2B) appear to retain somewhat more strength relative to the laminate articles containing the crack mitigating layer (Ex. 2A), the overall thickness of the crack mitigating layer in Ex. 2A is about 300 nm and the overall thickness of the crack mitigating stack in Ex. 2B is significantly thinner at about 165 nm. It should also be recognized that a wider range of combinations of organosilicate layer thickness, compositional variations, elastic modulus, and multilayer structures, for example detailed in the foregoing description, are expected to deliver similar results as those demonstrated in the present examples of laminate articles. For example, these organosilicate variations are expected to have minimal influence on surface and adhesion energies between the organosilicate layer and the underlying substrate and the scratch-resistant film over the organosilicate layer.

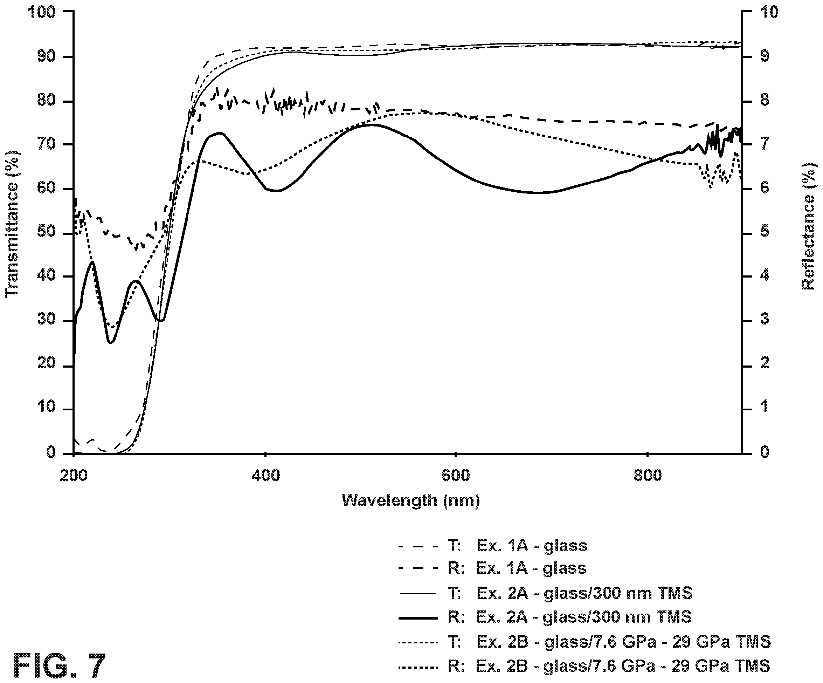

In FIG. 7, the reflectance and transmittance spectra are provided for the laminated articles designated Exs. 1A (i.e., a glass-based substrate control), and the crack mitigating layers of 2A and 2B from Example 1 above (without the $SiN_x$ scratch resistant layers). As a scratch-resistant film deployed over a crack mitigating layer would dominate the optimal properties of the laminate articles of the disclosure, it is judged that samples without such scratch-resistant films are representative for purposes of demonstrating the relative lack of any effect of the crack mitigating layer on the overall optical properties of the laminate articles of the disclosure. The prefix "R" and "T" in the legend denote series of data that correspond to reflectance and transmittance data, respectively. As shown in FIG. 7, the oscillations in the reflectance and transmittance spectra in the optical wavelength regime (i.e., from 400 nm to 800 nm) are no greater than about 10 to 15%. Further, the laminate articles having a crack mitigating layer or a crack mitigating stack comprising an organosilicate material (Ex. 2A and 2B) exhibit a transmittance of about 90% from about 400 nm to about 800 nm, roughly the same transmittance observed in the control samples of uncoated glass without any crack mitigating layer or stack.

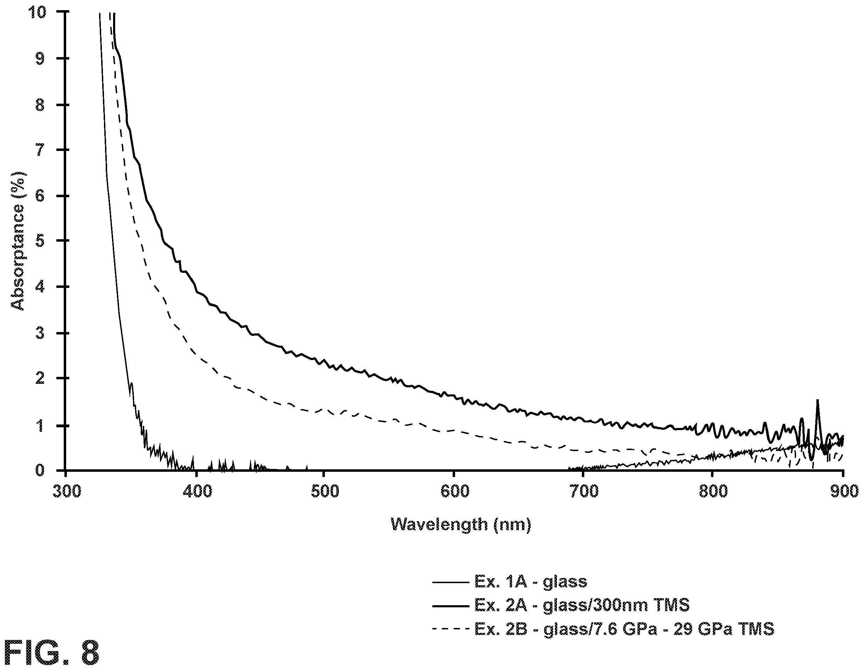

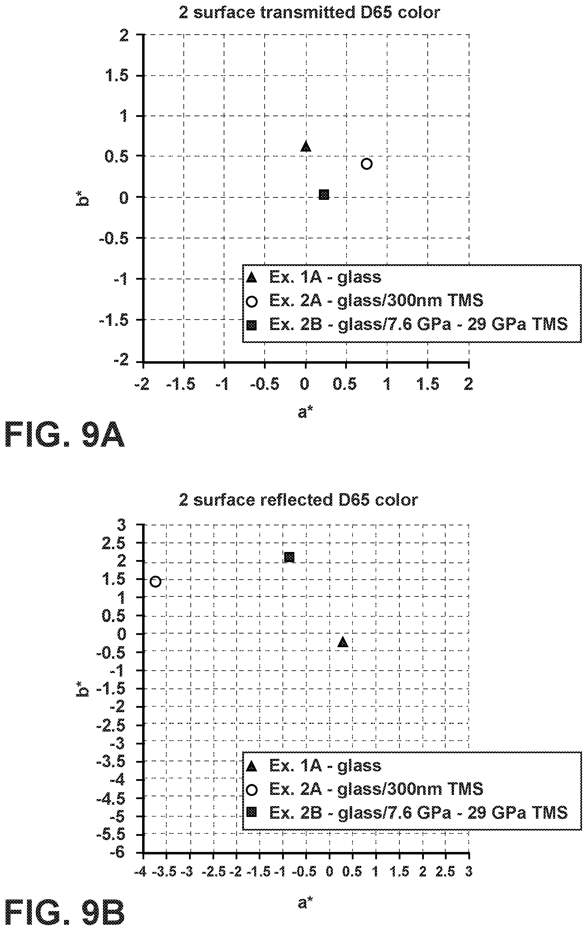

Referring to FIG. 8, this graph depicts Absorptance, A (i.e., A = 1-(R+T)) as a function of wavelength for Exs. 1A (i.e., a glass-based substrate control), 2A and 2B, where R is reflectance and T is transmittance. In this particular measurement, absorptance may also include scattered light. That is, the quantity "1-(R+T)" is equal to the difference between the sum of the transmittance and reflectance (as depicted in FIG. 7) and unity. Consequently, "1-(R+T)" reflects the amount of light absorbed and/or scattered, and not otherwise reflected or transmitted through the sample. In FIG. 8, it is apparent that the laminate article with the organosilicate crack mitigating layer (~300 nm thick) (i.e., Ex. 2A) exhibits some absorptance in the visible wavelength range. Further, the absorptance levels observed with regard to Ex. 2A are higher than the absorptance levels of Ex. 2B, the laminate article with the organosilicate crack mitigating stack (~ 165 nm thick), and even higher in comparison to the absorptance levels of the glass-based substrate control, Ex. 1A. Without being bound by theory, it is believed that the C-Si and C-C bonds in the organosilicate material within the crack mitigating layer and stack of Exs. 2A and 2B, respectively, are the source for these relatively higher absorptance levels in comparison to the absorptance of the uncoated, glass-based substrate control (Ex. 1). Referring now to FIGS. 9A and 9B, transmittance and reflectance color maps are provided that show a* and b* color coordinates for the Exs. 1A, 2A and 2B samples of Example 1 under D65 illumination. As is evident from the data plotted in these figures, the laminate articles that include the crack mitigating stack (Ex. 2B) are more color neutral than the laminated articles that include the crack mitigating layer (Ex. 2A). Further, the Ex. 2B samples, as comprising an organosilicate crack mitigating stack having an overall thickness of about 165 nm, are closer to the color coordinates of the glass-based substrate control sample, Ex. 1A, relative to the Ex. 2A samples, as comprising an organosilicate crack mitigating layer having a thickness of about 300 nm.

Example 2: FTIR spectral analysis of organosilicate layers suitable for crack mitigating layers and stacks

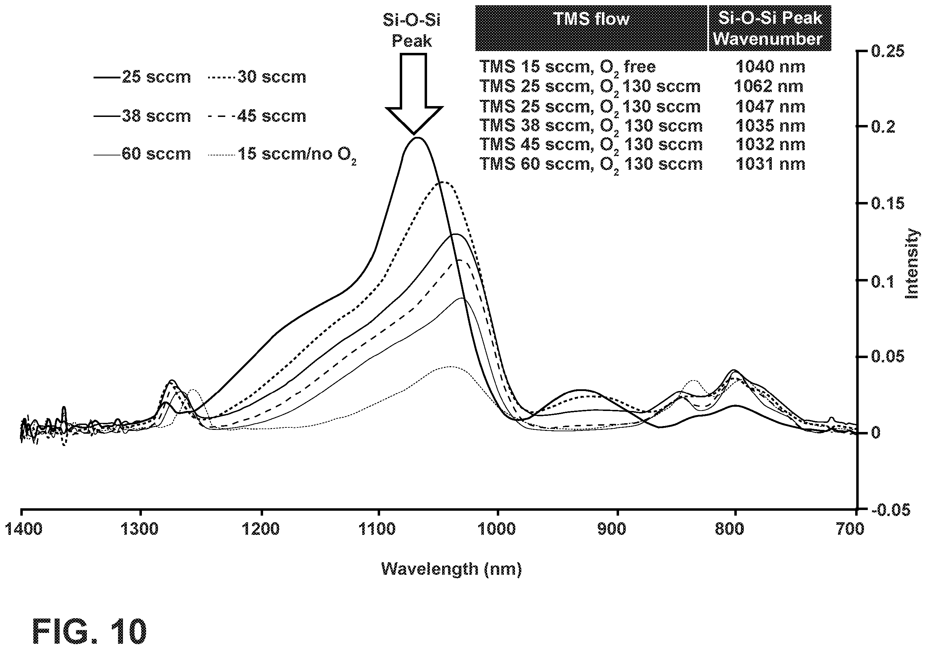

As detailed below in Table 1 and shown in FIG. 10, organosilicate layers were deposited on glass-based substrates using an APCVD process according to the specified conditions and analyzed using Fourier transform infrared spectroscopy (FTIR) techniques. More particularly, the organosilicate layers of this example have differing compositions in view of the differing process conditions (i.e., variable TMS/$O_2$ gas flow ratios), as noted in Table 1 and FIG. 10. As demonstrated by this data, the shift of the Si-O-Si peak from wavelengths of about 1020 nm to 1070 nm is an indication that the composition and/or structure of the organosilicate layer has changed. Without being bound by theory, it is believed that these changes are manifested in changes to the elastic modulus (see Table 1) and other properties of these layers. As outlined earlier, the introduction of $O_2$ gas into the TMS gas precursor tends to result in organosilicate layers and stacks with higher percentages of Si-O-Si backbones which, in turn, improves layer/stack strength and reduces the likelihood of coating cohesive failures.

Table 1 - FTIR data for organosilicate layers on glass-based substrates

| Deposition gas flow rate | Modulus (GPa) | Coating cohesive failure | FTIR Si-O-Si peak intensity height | FTIR Si-O-Si peak wavelength (nm) |
|---|---|---|---|---|
| TMS 15 sccm, no $O_2$ | 3.5 | Yes | 0.035 | 1040 |
| TMS 60 sccm, $O_2$ 130 sccm | 4.3 | No | 0.085 | 1031 |
| TMS 45 sccm, $O_2$ 130 sccm | 7.6 | No | 0.12 | 1032 |
| TMS 38 sccm, $O_2$ 130 sccm | 17.4 | No | 0.14 | 1035 |
| TMS 30 sccm, $O_2$ 130 sccm | 22 | No | 0.17 | 1047 |
| TMS 25 sccm, $O_2$ 130 sccm | 29 | No | 0.2 | 1062 |

While the disclosure has been described with respect to a limited number of embodiments for the purpose of illustration, those skilled in the art, having benefit of this disclosure, will appreciate that other embodiments can be devised which do not depart from the scope of the disclosure as disclosed herein.

As used herein, the term "about" means that amounts, sizes, formulations, parameters, and other quantities and characteristics are not and need not be exact, but may be approximate and/or larger or smaller, as desired, reflecting tolerances, conversion factors, rounding off, measurement error and the like, and other factors known to those of skill in the art. When the term "about" is used in describing a value or an end-point of a range, the disclosure should be understood to include the specific value or end-point referred to. Whether or not a numerical value or end-point of a range in the specification recites "about," the numerical value or end-point of a range is intended to include two embodiments: one modified by "about," and one not modified by "about." It will be further understood that the endpoints of each of the ranges are significant both in relation to the other endpoint, and independently of the other endpoint.

The terms "substantial," "substantially," and variations thereof as used herein (except when used in "substantially no peeling" which is defined elsewhere) are intended to note that a described feature is equal or approximately equal to a value or description. For example, a "substantially planar" surface is intended to denote a surface that is planar or approximately planar. Moreover, as defined above, "substantially similar" is intended to denote that two values are equal or approximately equal. In some embodiments, "substantially similar" may denote values within about 10% of each other, such as within about 5% of each other, or within about 2% of each other.

Directional terms as used herein-for example up, down, right, left, front, back, top, bottom-are made only with reference to the figures as drawn and are not intended to imply absolute orientation.

As used herein the terms "the," "a," or "an," mean "at least one," and should not be limited to "only one" unless explicitly indicated to the contrary. Thus, for example, reference to "a component" includes embodiments having two or more such components unless the context clearly indicates otherwise.

As used herein the term "glass-based" is meant to include any material made at least partially of glass, including glass and glass-ceramics. "Glass-ceramics" include materials produced through controlled crystallization of glass. In embodiments, glass-ceramics have about 30% to about 90% crystallinity. Non-limiting examples of glass ceramic systems that may be used include Li2O $\times$ Al2O3 $\times$ nSiO2 (i.e. LAS system), MgO $\times$ Al2O3 $\times$ nSiO2 (i.e. MAS system), and ZnO $\times$ Al2O3 $\times$ nSiO2 (i.e. ZAS system).

**Claims**

1. An article, comprising:

   a glass-based substrate (120) comprising opposing major surfaces;
   a crack mitigating stack (130b) disposed on one of the major surfaces; and
   a scratch-resistant film (110) disposed on the crack mitigating stack (130b), the film (110) comprising an elastic modulus greater than or equal to the elastic modulus of the glass-based substrate (120),
   wherein the crack mitigating stack (130b) comprises one or more bi-layers (23), wherein each bi-layer (23) is defined by: (a) a first layer (33) comprising an organosilicate material, and (b) a second layer (35) comprising an organosilicate material over the first layer (33), the first layer (33) comprising a lower elastic modulus than the elastic modulus of the second layer (35),
   wherein the scratch-resistant film (110) comprises at least one of a metal-containing oxide, a metal-containing oxynitride, a metal-containing nitride, a metal-containing carbide, a silicon-containing polymer, a carbon, a semiconductor, and combinations thereof, and
   further wherein the article is **characterized by** an average flexural strength that is at least 70% of an average flexural strength of the substrate (120).

2. The article of claim 1, wherein the first layer (33) is **characterized by** an elastic modulus from 1 GPa to 20 GPa, and the second layer (35) is **characterized by** an elastic modulus from 10 GPa to 40 GPa.

3. The article of claim 1 or claim 2, wherein the first layer (33) is further **characterized by** a thickness from 20 nanometers to 70 nanometers, and the second layer (35) is further **characterized by** a thickness from 5 nanometers to 40 nanometers, and
   wherein the crack mitigating stack (130b) has a thickness from 50 nanometers to 500 nanometers.

4. The article of any one of claims 1-3, wherein the crack mitigating stack (130b) comprises N bi-layers (23), and N is from 2 to 10.

5. The article of any one of claims 1-4, wherein the scratch-resistant film (110) comprises $SiO_2$, $Al_2O_3$, $TiO_2$, $Nb_2O_5$,

$Ta_2O_5$, $SiO_xN_y$, $Si_uAl_xO_yN_z$, $AlO_xN_y$, $SiN_x$, $AlN_x$, cubic boron nitride, $TiN_x$, SiC, TiC, WC, Si, Ge, indium-tin-oxide, tin oxide, fluorinated tin oxide, aluminum zinc oxide, zinc oxide, carbon nanotubes, graphene-doped oxide, siloxane-containing polymer, silsesquioxane-containing polymer, diamond-like-carbon, and combinations thereof.

**6.** The article of any one of claims 1-5, wherein the first and the second layers (33, 35) are defined by different compositions.

**7.** The article of any one of claims 1-6, wherein the optical transmittance of the crack mitigating stack (130b) coating onto the glass-based substrate (120) varies by 4% or less from the optical transmittance of the substrate (120) alone from wavelengths of 400 nanometers to 800 nanometers, and
wherein the optical transmittance of the article is 90% or greater from wavelengths of 400 nanometers to 800 nanometers.

**8.** The article of any one of claims 1-7, wherein the scratch-resistant film (110) is **characterized by** substantially no peeling from the article upon exposure of the film (110) to a Garnet scratch test under a 1 kg total load.

**9.** A device comprising:

a housing comprising front, back and side surfaces;
electrical components that are at least partially inside the housing; and
a display at or adjacent to the front surface of the housing,
wherein the article of any of the claims 1-8 is at least one of disposed over the display and disposed as a portion of the housing.

**Patentansprüche**

**1.** Artikel, umfassend:

ein glasbasiertes Substrat (120), das gegenüberliegende Hauptflächen umfasst; einen rissabschwächende Stapel (130b), der auf einer der Hauptflächen angeordnet ist; und eine kratzfeste Folie (110), die auf dem rissabschwächenden Stapel (130b) angeordnet ist, wobei die Folie (110) einen Elastizitätsmodul aufweist, der größer oder gleich dem Elastizitätsmodul des glasbasierten Substrats (120) ist,
wobei der rissabschwächende Stapel (130b) eine oder mehrere Doppelschichten (23) umfasst, wobei jede Doppelschicht (23) definiert ist durch: (a) eine erste Schicht (33), die ein Organosilikatmaterial umfasst, und (b) eine zweite Schicht (35), die ein Organosilikatmaterial umfasst, über der ersten Schicht (33), wobei die erste Schicht (33) einen niedrigeren Elastizitätsmodul als den Elastizitätsmodul der zweiten Schicht (35) umfasst,
wobei die kratzfeste Folie (110) mindestens eines von einem metallhaltigen Oxid, einem metallhaltigen Oxynitrid, einem metallhaltigen Nitrid, einem metallhaltigen Carbid, einem siliziumhaltigen Polymer, einem Kohlenstoff, einem Halbleiter und Kombinationen davon umfasst und
wobei der Artikel ferner durch eine durchschnittliche Biegefestigkeit gekennzeichnet ist, die mindestens 70 % einer durchschnittlichen Biegefestigkeit des Substrats (120) beträgt.

**2.** Artikel nach Anspruch 1, wobei die erste Schicht (33) durch einen Elastizitätsmodul von 1 GPa bis 20 GPa gekennzeichnet ist und die zweite Schicht (35) durch einen Elastizitätsmodul von 10 GPa bis 40 GPa gekennzeichnet ist.

**3.** Artikel nach Anspruch 1 oder Anspruch 2, wobei die erste Schicht (33) ferner durch eine Dicke von 20 Nanometer bis 70 Nanometer gekennzeichnet ist und die zweite Schicht (35) ferner durch eine Dicke von 5 Nanometer bis 40 Nanometer gekennzeichnet ist, und
wobei der rissabschwächende Stapel (130b) eine Dicke von 50 Nanometer bis 500 Nanometer aufweist.

**4.** Artikel nach einem der Ansprüche 1-3, wobei der rissabschwächende Stapel (130b) N Doppelschichten (23) umfasst und N 2 bis 10 beträgt.

**5.** Artikel nach einem der Ansprüche 1-4, wobei die kratzfeste Folie (110) $SiO_2$, $Al_2O_3$, $TiO_2$, $Nb_2O_5$, $Ta_2O_5$, $SiO_xN_y$, $Si_uAl_xO_yN_z$, $AlO_xN_y$, $SiN_x$, $AlN_x$, kubisches Bornitrid, $TiN_x$, SiC, TiC, WC, Si, Ge, Indiumzinnoxid, Zinnoxid, fluoriertes Zinnoxid, Aluminiumzinkoxid, Zinkoxid, Kohlenstoffnanoröhren, graphendotiertes Oxid, siloxanhaltiges Polymer, silsesquioxanhaltiges Polymer, diamantartigen Kohlenstoff und Kombinationen davon umfasst.

**6.** Artikel nach einem der Ansprüche 1-5, wobei die erste und die zweite Schicht (33, 35) durch unterschiedliche Zusammensetzungen definiert sind.

**7.** Artikel nach einem der Ansprüche 1-6, wobei die optische Durchlässigkeit der Beschichtung mit dem rissabschwächenden Stapel (130b) auf dem glasbasierten Substrat (120) um 4 % oder weniger von der optischen Durchlässigkeit des Substrats (120) allein von Wellenlängen von 400 Nanometer bis 800 Nanometer abweicht und wobei die optische Durchlässigkeit des Artikels 90 % oder mehr von Wellenlängen von 400 Nanometer bis 800 Nanometer beträgt.

**8.** Artikel nach einem der Ansprüche 1-7, wobei die kratzfeste Folie (110) durch im Wesentlichen keine Ablösung von dem Artikel bei Exposition der Folie (110) bei einem Granat-Kratztest unter einer Gesamtlast von 1 kg gekennzeichnet ist.

**9.** Vorrichtung, umfassend:

ein Gehäuse, das eine Vorder-, eine Rück- und Seitenflächen umfasst;
elektrische Komponenten, die sich mindestens teilweise innerhalb des Gehäuses befinden; und
eine Anzeige an der oder angrenzend an die Vorderfläche des Gehäuses,
wobei der Artikel nach einem der Ansprüche 1-8 mindestens eines von über der Anzeige angeordnet ist oder als Teil des Gehäuses angeordnet ist.

## Revendications

**1.** Article, comprenant :

un substrat à base de verre (120) comprenant des grandes surfaces opposées ;
un empilage anti-fissuration (130b) disposé sur l'une des grandes surfaces, et
un film résistant aux rayures (110) disposé sur l'empilage anti-fissuration (130b), le film (110) comprenant un module élastique supérieur ou égal au module élastique du substrat à base de verre (120),
où l'empilage anti-fissuration (130b) comprend une ou plusieurs bicouches (23), où chaque bicouche (23) est définie par : (a) une première couche (33) comprenant un matériau organosilicié, et (b) une deuxième couche (35) comprenant un matériau organosilicié par-dessus la première couche (33), la première couche (33) comprenant un module élastique inférieur au module élastique de la deuxième couche (35),
où le film résistant aux rayures (110) comprend au moins l'un de : un oxyde contenant un métal, un oxynitrure contenant un métal, un nitrure contenant un métal, un carbure contenant un métal , un polymère contenant du silicium, un carbone, un semi-conducteur et des combinaisons de ceux-ci, et
en outre où l'article est **caractérisé par** une résistance à la flexion moyenne qui est au moins 70 % d'une résistance à la flexion moyenne du substrat (120).

**2.** Article selon la revendication 1, où la première couche (33) est **caractérisée par** un module élastique de 1 GPa à 20 GPa, et la deuxième couche (35) est **caractérisée par** un module élastique de 10 GPa à 40 GPa.

**3.** Article selon la revendication 1 ou la revendication 2, où la première couche (33) est en outre **caractérisée par** une épaisseur de 20 nanomètres à 70 nanomètres, et la deuxième couche (35) est en outre **caractérisée par** une épaisseur de 5 nanomètres à 40 nanomètres, et où l'empilage anti-fissuration (130b) a une épaisseur de 50 nanomètres à 500 nanomètres.

**4.** Article selon l'une quelconque des revendications 1-3, où l'empilage anti-fissuration (130b) comprend N bicouches (23), et N est de 2 à 10.

**5.** Article selon l'une quelconque des revendications 1-4, où le film résistant aux rayures (110) comprend $SiO_2$, $Al_2O_3$, $TiO_2$, $Nb_2O_5$, $Ta_2O_5$, $SiO_xN_y$, $Si_uAl_xO_yN_z$, $AlO_xN_y$, $SiN_x$, $AlN_x$, nitrure de bore cubique, $TiN_x$, SiC, TiC, WC, Si, Ge, oxyde d'étain et d'indium, oxyde d'étain, oxyde d'étain fluoré, oxyde d'aluminium et de zinc, oxyde de zinc, nanotubes de carbone, oxyde dopé au graphène, polymère contenant du siloxane, polymère contenant du silsesquioxane, carbone de type diamant, et des combinaisons de ceux-ci.

**6.** Article selon l'une quelconque des revendications 1-5, où les première et deuxième couches (33, 35) sont définies par des compositions différentes.

7. Article selon l'une quelconque des revendications 1-6, où la transmittance optique du revêtement d'empilage anti-fissuration (130b) sur le substrat à base de verre (120) varie de 4% ou moins par rapport à la transmittance optique du substrat (120) seul aux longueurs d'ondes de 400 nanomètres à 800 nanomètres, et où la transmittance optique de l'article est de 90 % ou plus aux longueurs d'ondes de 400 nanomètres à 800 nanomètres.

8. Article selon l'une quelconque des revendications 1-7, où le film résistant aux rayures (110) est **caractérisé par** l'absence substantielle de décollement de l'article lors de l'exposition du film (110) à un essai de rayage de Garnet sous une charge totale de 1 kg.

9. Dispositif comprenant :

   un logement comprenant des surfaces avant, arrière et latérales ;
   des composants électriques qui sont au moins partiellement à l'intérieur du logement ; et
   un affichage sur la surface avant du logement ou adjacent à celle-ci,
   où l'article selon l'une quelconque des revendications 1-8 est au moins l'un de : disposé par-dessus l'affichage et disposé comme une partie du logement.

**FIG. 1A**

**FIG. 1B**

FIG. 2

$\mu_2, E_2, \nu_2$

12

$\mu_1, E_1, \nu_1$

10

$X_2$

$X_1$

**FIG. 3**

FIG. 4

**FIG. 5A**

**FIG. 5B**

FIG. 6

FIG. 7

Legend:
- - - T: Ex. 1A - glass
- - - R: Ex. 1A - glass
——— T: Ex. 2A - glass/300 nm TMS
——— R: Ex. 2A - glass/300 nm TMS
········ T: Ex. 2B - glass/7.6 GPa - 29 GPa TMS
········ R: Ex. 2B - glass/7.6 GPa - 29 GPa TMS

Axis labels:
- Transmittance (%)
- Reflectance (%)
- Wavelength (nm)

FIG. 8

**FIG. 9A**

**FIG. 9B**

FIG. 10

EP 3 558 887 B1

FIG. 11

FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016138195 A1
- WO 2016176383 A1
- US 9079802 B
- US 9355444 B
- US 9359261 B
- US 9366784 B

**Non-patent literature cited in the description**

- **FISCHER-CRIPPS, A.C.** Critical Review of Analysis and Interpretation of Nanoindentation Test Data. *Surface & Coatings Technology,* 2006, vol. 200, 4153-4165
- **HAY, J. ; AGEE, P ; HERBERT, E.** Continuous Stiffness measurement During Instrumented Indentation Testing. *Experimental Techniques,* 2010, vol. 34 (3), 86-94
- **MING-YUAN, H. ; J.W. HUTCHINSON.** Crack deflection at an interface between dissimilar elastic materials. *International Journal of Solids and Structures,* 1989, vol. 25 (9), 1053-1067
- **ZENG, K. et al.** Investigation of mechanical properties of transparent conducting oxide thin films. *Thin Solid Films,* 2003, vol. 443 (1-2), 60-65
- **COTTERELL, B. ; Z. CHEN.** Buckling and cracking of thin films on compliant substrates under compression. *International Journal of Fracture,* 2000, vol. 104 (2), 169-179
- **L. A. GIRIFALCO ; R. J. GOOD.** A theory for the estimation of surface and interfacial energies, I. derivation and application to interfacial tension. *Journal of Physical Chemistry,* vol. 61, 904
- **S. WU.** *J. Polym. Sci., Part C,* 1971, vol. 34, 19-30